(19) Europäisches Patentamt
European Patent Office
Office européen des brevets

(11) **EP 3 428 584 B1**

(12) **EUROPÄISCHE PATENTSCHRIFT**

(45) Veröffentlichungstag und Bekanntmachung des Hinweises auf die Patenterteilung:
**08.04.2020 Patentblatt 2020/15**

(21) Anmeldenummer: **18182764.3**

(22) Anmeldetag: **10.07.2018**

(51) Int Cl.:
*G01F 1/716* *(2006.01)*      *G01N 24/08* *(2006.01)*
*G01R 33/36* *(2006.01)*      *G01R 33/563* *(2006.01)*
*G01R 33/565* *(2006.01)*

(54) **KERNMAGNETISCHES MESSGERÄT**

NUCLEAR MAGNETIC MEASURING DEVICE

APPAREIL DE MESURE MAGNÉTIQUE NUCLÉAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **13.07.2017 DE 102017115807**

(43) Veröffentlichungstag der Anmeldung:
**16.01.2019 Patentblatt 2019/03**

(73) Patentinhaber: **Krohne AG**
**4019 Basel (CH)**

(72) Erfinder:
• **Picco, Facundo**
**3311VL Dordrecht (NL)**
• **Carletti, Luciano Martin**
**3311CE Dordrecht (NL)**

(74) Vertreter: **Gesthuysen Patent- und Rechtsanwälte**
**Patentanwälte**
**Huyssenallee 100**
**45128 Essen (DE)**

(56) Entgegenhaltungen:
**EP-A1- 1 810 047      EP-A1- 2 733 500**
**US-A- 5 903 150      US-A1- 2012 001 629**
**US-B1- 7 123 009**

EP 3 428 584 B1

**Beschreibung**

Die Erfindung betrifft ein kernmagnetisches Messgerät mit einer Messvorrichtung zur Durchführung von kernmagnetischen Messungen an einem Medium.

Dokument EP 2 733 500 A1 offenbart ein kernmagnetisches Messgerät.

Dazu weist die Messvorrichtung eine Steuerungseinrichtung, eine Generatoreinrichtung, eine erste und eine zweite Konditionierungseinrichtung, eine Antenneneinrichtung, eine Empfangseinrichtung und einen Messsignalpfad auf. Der Messsignalpfad umfasst einen Anregungssignalpfad und einen Reaktionssignalpfad und die Antenneneinrichtung weist einen Antennensignalpfad auf. Dabei fallen der Anregungssignalpfad und der Reaktionssignalpfad im Antennensignalpfad zusammen.

Die Generatoreinrichtung ist zur Erzeugung von Anregungssignalen, die erste Konditionierungseinrichtung zur Konditionierung der Anregungssignale und die Antenneneinrichtung zur Übertragung der konditionierten Anregungssignale auf das Medium ausgebildet. Weiter ist die Antenneneinrichtung auch zur Detektion von durch die Anregungssignale im Medium hervorgerufenen Reaktionssignalen, die zweite Konditionierungseinrichtung zur Konditionierung der Reaktionssignale und die Empfangseinrichtung zum Empfangen der konditionierten Reaktionssignale ausgebildet. Die Steuerungseinrichtung ist insbesondere zur Steuerung der Generatoreinrichtung und der Empfangseinrichtung ausgebildet. Weiter ist die Steuerungseinrichtung zur Auswertung der Reaktionssignale ausgestaltet.

Der Anregungssignalpfad führt die Anregungssignale von der Generatoreinrichtung über die erste Konditionierungseinrichtung und über die Antenneneinrichtung auf das Medium und der Reaktionssignalpfad führt die Reaktionssignale vom Medium über die Antenneneinrichtung und über die zweite Konditionierungseinrichtung zur Empfangseinrichtung. Somit erstreckt sich der Anregungssignalpfad von der Generatoreinrichtung bis ins Medium hinein und liegen die erste Konditionierungseinrichtung und die Antenneneinrichtung im Anregungssignalpfad. Der Reaktionssignalpfad erstreckt sich aus dem Medium heraus bis zur Empfangseinrichtung und liegen die Antenneneinrichtung und die zweite Konditionierungseinrichtung im Reaktionssignalpfad.

Das kernmagnetische Messgerät ist ausgebildet, im Betrieb kernmagnetische Messungen an einem Medium durchzuführen und aus den kernmagnetischen Messungen Informationen über das Medium zu bestimmen. Bei der Durchführung einer kernmagnetischen Messung durch die Messvorrichtung wird eine Präzession von Atomkernen des Mediums bei Anwesenheit eines makroskopischen Magnetfelds, welches das Mediums zuvor magnetisiert hat, durch Anregung der Atomkerne zu kernmagnetischen Resonanzen beeinflusst und werden die kernmagnetischen Resonanzen ausgewertet. Deshalb werden kernmagnetische Messungen oftmals auch als kernmagnetische Resonanzmessungen oder Magnetresonanzmessungen bezeichnet und entsprechende Messgeräte als kernmagnetische Resonanzmessgeräte oder Magnetresonanzmessgeräte. Zur Erzeugung des makroskopischen Magnetfelds weist das kernmagnetische Messgerät eine Magnetfelderzeugungsvorrichtung auf.

Präzession ist eine Eigenschaft von Atomkernen der Elemente, die einen Kernspin aufweisen. Der Kernspin kann als ein durch einen Vektor beschreibbarer Drehimpuls aufgefasst werden und entsprechend kann auch das durch den Kernspin hervorgerufene magnetische Moment durch einen Vektor beschreiben werden, der parallel zum Vektor des Drehimpulses ist. Die Anwesenheit eines makroskopischen Magnetfelds bewirkt einen Überschuss an Atomkernen mit magnetischen Momenten in einem Medium, die parallel zum makroskopischen Magnetfeld ausgerichtet sind, wodurch das Medium eine makroskopische Magnetisierung aufweist, die in ihrer Gesamtheit durch einen Vektor beschrieben werden kann. Der Vektor des magnetischen Moments eines Atomkerns präzessiert bei Anwesenheit eines makroskopischen Magnetfelds um den Vektor des makroskopischen Magnetfelds an der Stelle des Atomkerns. Das ist die Eigenschaft Präzession. Die Frequenz der Präzision wird als Larmorfrequenz $\omega_L$ bezeichnet und ist proportional zum Betrag der magnetischen Flussdichte B des makroskopischen Magnetfelds. Die Larmorfrequenz berechnet sich gemäß $\omega_L = \gamma\, B$. Darin ist $\gamma$ das gyromagnetische Verhältnis, welches für Wasserstoffkerne maximal ist.

Die Anregung der Atomkerne zu kernmagnetischen Resonanzen erfolgt durch Anregungssignale in Form von Mess-Anregungssignalen. Anregungssignale sind zumeist RF-Signale und werden von der Generatoreinrichtung erzeugt, dann vom Anregungssignalpfad zur ersten Konditionierungseinrichtung und auf dem Anregungssignalpfad durch die erste Konditionierungseinrichtung geführt, in welcher sie konditioniert werden. Die konditionierten Anregungssignale werden dann vom Anregungssignalpfad zur Antenneneinrichtung und auf dem Anregungssignalpfad durch die Antenneneinrichtung geführt. Die Antenneneinrichtung überträgt die konditionierten Anregungssignale auf das Medium. Die Generatoreinrichtung weist zur Erzeugung der Anregungssignale oftmals einen Digital-Analog-Umsetzer und die erste Konditionierungseinrichtung zur Konditionierung der Anregungssignale für gewöhnlich einen Verstärker auf. Bei dem Verstärker handelt es sich für gewöhnlich um einen Leistungsverstärker.

Kernmagnetische Resonanzen werden als im Medium hervorgerufene Reaktionssignale in Form von Mess-Reaktionssignalen von der Antenneneinrichtung detektiert. Reaktionssignale werden aus dem Medium vom Reaktionssignalpfad zur Antenneneinrichtung und dann auf dem Reaktionssignalpfad durch die Antenneneinrichtung geführt. Weiter werden die Reaktionssignale vom Reaktionssignalpfad zur zweiten Konditionierungseinrichtung und auf dem Reaktionssignalpfad durch die Konditionierungseinrichtung gerührt, in welcher sie konditioniert werden. Die konditionierten Reaktionssignale werden dann vom Reaktionssignalpfad zur Empfangseinrichtung geführt, von welcher sie empfangen werden. Die Empfangseinrichtung weist zum Empfangen der konditionierten Reaktionssignale oftmals einen Analog-Digital-Umsetzer und die zweite Konditionierungseinrichtung zur Konditionierung der Reaktionssignale einen Verstärker auf. Bei dem Verstärker handelt es sich für gewöhnlich um einen zur Verstärkung von im Vergleich zu den Anregungssignalen sehr schwachen Signalen.

Mess-Anregungssignale sind Anregungssignale und Anregungssignale weisen grundsätzlich mindestens einen elektromagnetischen RF-Puls auf. Zumindest bei Mess-Anregungssignalen weist ein solcher RF-Puls zumeist die Larmorfrequenz auf. Mess-Anregungssignale weisen zum Beispiel einen Aktivierungspuls und mindestens einen Refokussierungspuls auf. Ein Aktivierungspuls bewirkt eine kernmagnetische Resonanz in Form einer zum Vektor des makroskopischen Magnetfelds transversalen makroskopischen Magnetisierung des Mediums, welche mit der Larmorfrequenz um den Vektor des makroskopischen Magnetfelds rotiert. Die rotierende transversale makroskopische Magnetisierung kann als ein Mess-Reaktionssignal in Form eines freien Induktionszerfalls, der im Englischen als "Free Induction Decay" bezeichnet und als FID abgekürzt wird, und/oder, nach einer Refokussierung als ein Echosignal detektiert werden. Somit weist ein Mess-Reaktionssignal einen freien Induktionszerfall und/oder mindestens ein Echosignal auf. Eine Refokussierung der rotierenden transversalen Magnetisierung ist dann erforderlich, wenn die nach dem Aktivierungspuls oder Refokussierung zunächst vorhandene Beziehung der Phasen der Präzessionen der einzelnen magnetischen Momente der Atomkerne zueinander zum Beispiel durch Inhomogenitäten im makroskopischen Magnetfeld gestört ist. Eine Refokussierung erfolgt durch einen Refokussierungspuls, welcher die Beziehung der Phasen wiederherstellt und Teil eines Mess-Anregungssignals ist.

Die Antenneneinrichtung weist den Antennensignalpfad auf, in welchem der Anregungssignalpfad und der Reaktionssignalpfad zusammenfallen. Weiter weist die Antenneneinrichtung für gewöhnlich einen Antennenwechselschalter auf, welcher in einem ersten Schaltzustand den Antennensignalpfad mit dem Anregungssignalpfad verbindet und in einem zweiten Schaltzustand den Antennensignalpfad mit dem Reaktionssignalpfad verbindet. Der Antennenwechselschalter kann als aktiver oder passiver Wechselschalter ausgebildet sein. Oftmals ist der Antennenwechselschalter ein passiver Wechselschalter, dessen Schaltzustand abhängig von der Leistung eines Signals ist, welches sich über den Messsignalpfad ausbreitet. Übersteigt die Leistung einen bestimmten Leistungsschwellenwert, so ist der Antennenwechselschalter im ersten Schaltzustand und ist die Leistung unterhalb des bestimmten Leistungsschwellenwerts, dann ist er im zweiten Schaltzustand. Für gewöhnlich weisen passive Antennenwechselschalter Dioden als Schaltelemente auf. Wenn der Antennenwechselschalter als aktiver Wechselschalter ausgebildet ist, dann ist er für gewöhnlich steuerbar. Zumeist wird der Antennenwechselschalter von der Steuerungseinrichtung gesteuert. Somit führt der Antennensignalpfad sowohl die Anregungssignale als auch die Empfangssignale und in diesem Sinne fallen der Anregungssignalpfad und der Reaktionssignalpfad im Antennensignalpfad zusammen.

Für gewöhnlich weist die Antenneneinrichtung eine Spuleneinrichtung auf. Die Spuleneinrichtung weist zumeist eine einzige Spule sowohl zur Übertragung der Anregungssignale auf das Medium als auch zur Detektion der Reaktionssignale aus dem Medium auf. Es gibt jedoch auch Spuleneinrichtungen, welche eine erste Spule zur Übertragung der Anregungssignale auf das Medium und eine zweite Spule zur Detektion der Reaktionssignale aus dem Medium aufweisen. Die Antenneneinrichtung ist für gewöhnlich als Resonanzschwingkreis mit einer Resonanzfrequenz ausgestaltet und weist eine Tuning-Schaltung auf. Die Tuning-Schaltung ist ausgebildet, die Resonanzfrequenz des Resonanzschwingkreises unter Berücksichtigung der Larmorfrequenz einzustellen, insbesondere die Resonanzfrequenz auf die Larmorfrequenz einzustellen. Weiter weist die Antenneneinrichtung für gewöhnlich eine Matching-Schaltung zur Vermeidung von Signalreflexionen am Übergang von Anregungssignalpfad oder Reaktionssignalpfad auf der einen Seite und Antennensignalpfad auf der anderen Seite auf.

Das Medium weist oftmals auch mehrere Phasen auf. Zur Bestimmung von Informationen über die einzelnen Phasen müssen Atomkerne der einzelnen Phasen zu unterscheidbaren kernmagnetischen Resonanzen anregbar sein. Zum Beispiel sind kernmagnetische Resonanzen voneinander unterscheidbar, wenn longitudinale Relaxationen der einzelnen Phasen voneinander verschiedene longitudinale Relaxationszeitkonstanten $T_1$ aufweisen. Da das aus Ölquellen geförderte mehrphasige Medium im Wesentlichen als flüssigen Phasen Rohöl und (Salz-) Wasser und als gasförmige Phase Erdgas aufweist, die Atomkerne aller Phasen Wasserstoffkerne besitzen und sich für gewöhnlich insbesondere die Phasen Rohöl und (Salz-) Wasser durch unterschiedliche longitudinale Relaxationszeitkonstanten $T_1$ auszeichnen, sind kernmagnetische Messgeräte für die Bestimmung von Informationen von aus Ölquellen geförderten Medien besonders geeignet.

Bei Untersuchungen an kernmagnetischen Messgeräten der beschriebenen Art ist erkannt worden, dass Eigenschaften des Messsignalpfads Schwankungen unterliegen, diese Eigenschaften also instabil sind. Es ist erkannt worden, dass die Schwankungen verschiedene Ursachen haben. Ursachen sind zum Beispiel Temperaturabhängigkeiten, Serienstreuungen und Alterungen von Komponenten im Messsignalpfad wie zum Beispiel der Steuerungseinrichtung, der Generatoreinrichtung, der ersten und zweiten Konditionierungseinrichtung, der Antenneneinrichtung und der Empfangseinrichtung. Auch Eigenschaften des Mediums sind temperaturabhängig. Eine weitere Ursache ist die Belastung des Messsignalpfads durch das Medium, wobei die Belastung insbesondere von der Leitfähigkeit des Mediums abhängt.

Eine Aufgabe der vorliegenden Erfindung ist daher die Angabe von einem kernmagnetischen Messgerät der beschriebenen Art, welches mindestens eine instabile Eigenschaft des Messsignalpfads bestimmt.

Die Aufgabe ist gemäß der Erfindung zunächst und im Wesentlichen dadurch gelöst, dass die Messvorrichtung einen Umgehungssignalpfad und eine Übertragungseinrichtung aufweist, der Umgehungssignalpfad und die Übertragungseinrichtung miteinander verbunden sind und die Übertragungseinrichtung zur bidirektionalen Übertragung von Signalen zwischen dem Umgehungssignalpfad und dem Antennensignalpfad ausgebildet ist. Die bidirektionale Übertragung von Signalen zwischen dem Umgehungssignalpfad und dem Antennensignalpfad bezieht sich insbesondere auf die Übertragung von Anregungssignalen vom Umgehungssignalpfad auf den Antennensignalpfad und die Übertragung von Reaktionssignalen vom Antennensignalpfad auf den Umgehungssignalpfad.

Weiter ist die Erfindung dadurch gekennzeichnet, dass ein erster Wechselschalter derart angeordnet ist, dass in einem ersten Schaltzustand die Generatoreinrichtung mit dem Anregungssignalpfad und einem zweiten Schaltzustand die Generatoreinrichtung mit dem Umgehungssignalpfad verbunden ist, und dass ein zweiter Wechselschalter derart angeordnet ist, dass in einem ersten Schaltzustand die Empfangseinrichtung mit dem Reaktionssignalpfad und in einem zweiten Schaltzustand die Empfangseinrichtung mit dem Umgehungssignalpfad verbunden ist. Der erste und der zweite Wechselschalter weisen jeweils einen ersten und einen zweiten Schaltzustand auf und die Schaltzustände sind steuerbar.

Darüber hinaus ist die Erfindung dadurch gekennzeichnet, dass die Steuerungseinrichtung ausgebildet ist, zunächst den ersten Wechselschalter und den zweiten Wechselschalter anzusteuern, sodass ein Teil des Messsignalpfads durch den Umgehungssignalpfad umgangen ist, und dann mit der Generatoreinrichtung ein Test-Anregungssignal zu erzeugen, ein vom Test-Anregungssignal hervorgerufenes Test-Reaktionssignal mit der Empfangseinrichtung zu empfangen und unter Verwendung des Test-Anregungssignals und des Test-Reaktionssignals eine Eigenschaft des Messsignalpfads zu bestimmen, wobei die Eigenschaft eine instabile Eigenschaft des Messsignalpfads ist. Da der Messsignalpfad nicht nur die Messvorrichtung, sondern auch das Medium umfasst, umfassen die instabilen Eigenschaften nicht nur die der Messvorrichtung, sondern auch die des Mediums. Die beschriebene Ausbildung der Steuerungseinrichtung bewirkt, dass die Steuerungseinrichtung im Betrieb Entsprechendes ausführt. Gleiches gilt für beliebige Ausgestaltungen der Steuerungseinrichtung.

Ein Vorteil des erfindungsgemäßen kernmagnetischen Messgeräts gegenüber den beschriebenen kernmagnetischen Messgeräten ist, dass es ausgebildet ist, eine instabile Eigenschaft des Messsignalpfads zu bestimmen.

Durch die Anordnung des ersten Wechselschalters im ursprünglichen Anregungssignalpfad und des zweiten Wechselschalters im ursprünglichen Reaktionssignalpfad sind zur Durchführung von kernmagnetischen Messungen Änderungen an der Ausgestaltung der Steuerungseinrichtung vorzunehmen. Deshalb ist in einer Ausgestaltung des erfindungsgemäßen kernmagnetischen Messgeräts vorgesehen, dass die Steuerungseinrichtung ausgebildet ist, eine kernmagnetische Messung durchzuführen, indem die Steuerungseinrichtung zunächst sowohl den ersten als auch den zweiten Wechselschalter in den jeweils ersten Schaltzustand bringt und dann ein Mess-Anregungssignal erzeugt, ein vom Mess-Anregungssignal hervorgerufenes Mess-Reaktionssignal empfängt und unter Verwendung des Mess-Anregungssignals und des Messreaktionssignals eine Information über das Medium bestimmt.

Wenn der erste Wechselschalter im ersten Schaltzustand ist, erstreckt sich der Anregungssignalpfad von der Generatoreinrichtung bis hinein ins Medium, und wenn der zweite Wechselschalter im ersten Schaltzustand ist, erstreckt sich der Reaktionssignalpfad vom Medium bis zur Empfangseinrichtung. Der Umgehungssignalpfad ist abgekoppelt.

Wenn es heißt, dass die Steuerungseinrichtung ein Anregungssignal wie das Mess-Anregungssignal erzeugt, ist damit gemeint, dass die Steuerungseinrichtung die Generatoreinrichtung entsprechend ansteuert. Wenn es heißt, dass die Steuerungseinrichtung ein Reaktionssignal wie das Mess-Reaktionssignal empfängt, ist damit gemeint, dass die Steuerungseinrichtung die Empfangseinrichtung entsprechend ansteuert.

Bei der Information über das Medium handelt es sich zum Beispiel um eine Geschwindigkeit des Mediums oder, wenn es sich um ein mehrphasiges Medium handelt, um eine Geschwindigkeit einer Phase des Mediums oder um eine Eigenschaft des Mediums selbst wie zum Beispiel die Anteile der einzelnen Phasen am Medium, eine longitudinale Relaxationszeitkonstante $T_1$ oder eine transversale Relaxationszeitkonstante $T_2$. Wenn das kernmagnetische Messgerät eine Geschwindigkeit eines Mediums oder eine Geschwindigkeit einer Phase eines Mediums misst, ist es vorteilhaft, wenn das Messgerät zusätzlich ein Messrohr aufweist, durch welches das Medium strömt. Ein solches kernmagnetisches Messgerät wird auch als kernmagnetisches Durchflussmessgerät bezeichnet. Vorzugsweise ist ein kernmagnetisches Durchflussmessgerät auch zur Bestimmung von weiteren Eigenschaften ausgebildet.

In einer Weiterbildung der vorangehenden Ausgestaltung des kernmagnetischen Messgeräts ist vorgesehen, dass die Steuerungseinrichtung darüber hinaus ausgebildet ist, eine Genauigkeit der Information über das Medium unter Verwendung der bestimmten Eigenschaft des Messsignalpfads zu erhöhen. Dieser Ausgestaltung liegt die Erkenntnis zugrunde, dass die Berücksichtigung einer Schwankung einer instabilen Eigenschaft des Messsignalpfads bei der Bestimmung einer Information über das Medium durch eine kernmagnetische Messung eine Erhöhung der Genauigkeit bei der Bestimmung dieser Information bewirkt.

Es ist erkannt worden, dass eine solche instabile erste Eigenschaft eine Verstärkung über den Reaktionssignalpfad ist. Die Verstärkung über den Reaktionssignalpfad ist dabei die Verstärkung, die ein Signal erfährt, wenn es sich entlang des Reaktionssignalpfads ausbreitet. Deshalb ist in einer weiteren Ausgestaltung vorgesehen, dass die Steuerungseinrichtung ausgebildet ist, die erste Eigenschaft des Messsignalpfads zu bestimmen, indem die Steuerungseinrichtung zunächst den ersten Wechselschalter in den zweiten Schaltzustand und den zweiten Wechselschalter in den ersten Schaltzustand bringt und dann ein erstes Test-Anregungssignal erzeugt, ein vom ersten Test-Anregungssignal hervorgerufenes erstes Test-Reaktionssignal empfängt und unter Verwendung des ersten Test-Anregungssignals und des ersten Test-Reaktionssignals die Verstärkung über den Reaktionssignalpfad als die erste Eigenschaft bestimmt.

Wenn der erste Wechselschalter im zweiten Schaltzustand und der zweite Wechselschalter im ersten Schaltzustand sind, dann ist der Teil des Anregungssignalpfads durch den Umgehungssignalpfad umgangen, der sich vom ersten Wechselschalter bis zur Übertragungseinrichtung erstreckt. In diesem Teil des Anregungssignalpfads liegt insbesondere die erste Konditionierungseinrichtung. Die Generatoreinrichtung ist ausgebildet, das erste Test-Anregungssignal als Anregungssignal zu erzeugen. Das Test-Anregungssignal ist zum Beispiel ein Mess-Anregungssignal oder ein Teil von einem Mess-Anregungssignal. Das von der Generatoreinrichtung erzeugte erste Test-Anregungssignal breitet sich durch den ersten Wechselschalter und dann über den Umgehungssignalpfad zur Übertragungseinrichtung aus. Die Übertragungseinrichtung überträgt das Test-Anregungssignal vom Umgehungssignalpfad auf den Reaktionssignalpfad. Weiter breitet sich das Test-Anregungssignal über den Reaktionssignalpfad durch die zweite Konditionierungseinrichtung und dann durch den zweiten Wechselschalter zur Empfangseinrichtung aus. Durch die Umgehung des beschriebenen Teils des Anregungssignalpfads ist das Test-Anregungssignal durch instabile Eigenschaften insbesondere der ersten Konditionierungseinrichtung unbeeinflusst, wodurch das Test-Anregungssignal an der Übertragungseinrichtung dem an der Generatoreinrichtung entspricht. Das Test-Anregungssignal wird somit nur durch instabile Eigenschaften des Reaktionssignalpfad beeinflusst, wozu insbesondere instabile Eigenschaften der zweiten Konditionierungseinrichtung und für gewöhnlich auch des Mediums gehören. Durch die Beeinflussung des Test-Anregungssignals über den Reaktionssignalpfad wird aus dem ersten Test-Anregungssignal das erste Test-Reaktionssignal. Die Empfangseinrichtung ist ausgebildet, das erste Test-Reaktionssignal als Reaktionssignal zu empfangen. Somit ist in dem Test-Anregungssignal und dem Test-Reaktionssignal zusammen genommen die Information über die Verstärkung über den Reaktionssignalpfad enthalten. Erfindungsgemäß ist erkannt worden, dass die auf diese Weise bestimmte Verstärkung über den Reaktionssignalpfad zwischen der Übertragungseinrichtung und der Empfangseinrichtung der Verstärkung eines Mess-Reaktionssignals über dem Reaktionssignalpfad entspricht.

Wenn die Steuerungseinrichtung ausgebildet ist, neben der kernmagnetischen Messung auch mindestens eine Bestimmung der ersten Eigenschaft auszuführen, gibt es mehrere Ausgestaltungen für die zeitliche Abfolge der Ausführung der mindestens einen Bestimmung der ersten Eigenschaft und der Ausführung der kernmagnetischen Messung. Im Betrieb des kernmagnetischen Messgeräts führt die Steuerungseinrichtung Entsprechendes aus.

In einer diesbezüglichen Ausgestaltung ist vorgesehen, dass die Steuerungseinrichtung ausgebildet ist, die mindestens eine Bestimmung der ersten Eigenschaft außerhalb der Ausführung der kernmagnetischen Messung auszuführen. Somit besteht zwischen der Ausführung der mindestens einen Bestimmung der ersten Eigenschaft und der Ausführung der kernmagnetischen Messung ein zeitlicher Abstand. Durch den zeitlichen Abstand erfolgen die jeweiligen Ausführungen sequenziell, weshalb diese Ausgestaltung auf einfache Weise in der Messvorrichtung zu implementieren ist.

In einer weiteren diesbezüglichen Ausgestaltung ist vorgesehen, dass die Steuerungseinrichtung ausgebildet ist, die mindestens eine Bestimmung der ersten Eigenschaft während der Ausführung der kernmagnetischen Messung auszuführen. Während der Ausführung der kernmagnetischen Messung wird das Mess-Anregungssignal erzeugt, welches zumindest einen RF-Puls umfasst. Dieser RF-Puls ist zum Beispiel ein Aktivierungspuls. Der Aktivierungspuls bewirkt einen freien Induktionszerfall, welcher Teil des Mess-Reaktionssignals ist. Vorzugsweise erfolgt die mindestens eine Bestimmung der ersten Eigenschaft über ein Intervall des freien Induktionszerfalls, welches von der Steuerungseinrichtung nicht als Teil des Mess-Reaktionssignals ausgewertet wird, wodurch eine gegenseitige Beeinflussung vermieden wird. Das trifft zum Beispiel für den Teil des freien Induktionszerfalls zu, der eine Amplitude aufweist, die für eine Auswertung durch die Steuerungseinrichtung zu klein ist. Für gewöhnlich weist das Mess-Anregungssignal neben dem Aktivierungspuls auch mindestens einen Refokussierungspuls auf. Dementsprechend weist das Mess-Reaktionssignal dann neben dem freien Induktionsverfall auch mindestens ein Echosignal auf. Vorzugsweise erfolgt die mindestens eine Bestimmung der ersten Eigenschaft dann auch oder alternativ über ein Intervall des Echosignals, welches von der Steuerungseinrichtung nicht als Teil des Mess-Reaktionssignals ausgewertet wird, wodurch eine gegenseitige Beeinflussung vermieden wird. Das trifft zum Beispiel für den Teil des Echosignals zu, der eine Amplitude aufweist, die für eine Auswertung durch die Steuerungseinrichtung zu klein ist. Diese Ausgestaltung reduziert den Zeitbedarf für die Ausführung der mindestens einen Bestimmung der ersten Eigenschaft und der Ausführung der kernmagnetischen Messung. Jedoch ist die Implementierung dieser Ausgestaltung in der Steuerungseinrichtung aufwendiger als die Implementierung der vorangehenden Ausgestaltung.

Wenn die Steuerungseinrichtung im Betrieb mehrere Bestimmungen der ersten Eigenschaft ausführt, so können diese Bestimmungen nicht nur entweder außerhalb oder während der Ausführung der kernmagnetischen Messung ausgeführt werden, sondern können auch beliebige Kombinationen von Ausführungen der Bestimmungen der ersten Eigenschaft außerhalb und während der Ausführung der kernmagnetischen Messung ausgeführt werden.

Wenn die Steuerungseinrichtung ausgebildet ist, die erste Eigenschaft des Messsignalpfads zu bestimmen, dann ist es vorteilhaft, die Steuerungseinrichtung weiter auszubilden, mindestens eine erste und eine zweite Bestimmung der ersten Eigenschaft auszuführen und eine Interpolation der ersten Eigenschaft zwischen der mindestens ersten und zweiten Bestimmung der ersten Eigenschaft durchzuführen. Die Interpolation ermöglicht eine Bestimmung der ersten Eigenschaft auch zeitlich zwischen der mindestens ersten und zweiten Bestimmung der ersten Eigenschaft.

Zur Kompensation oder zumindest Reduktion des Einflusses von Schwankungen der Verstärkung über den Reaktionssignalpfad, also der bestimmten ersten Eigenschaft, auf ein Reaktionssignal wie das Mess-Reaktionssignal einer kernmagnetischen Messung ist es vorteilhaft, einen Verstärkungskorrekturfaktor zu bestimmen, der bei Multiplikation mit dem Reaktionssignal dieses von dem Einfluss der Schwankung der Verstärkung befreit oder den Einfluss zumindest reduziert.

Deshalb ist in einer Ausgestaltung des kernmagnetischen Messgeräts vorgesehen, dass die Steuerungseinrichtung weiter ausgebildet ist, sowohl den ersten Wechselschalter als auch den zweiten Wechselschalter jeweils in den ersten Schaltzustand zu bringen und dann ein erstes Referenz-Anregungssignal zu erzeugen, ein vom ersten Referenz-Anregungssignal hervorgerufenes erstes Referenz-Reaktionssignal zu empfangen, eine erste Referenz-Amplitude des ersten Referenz-Reaktionssignals und unter Verwendung des ersten Referenz-Anregungssignals und des ersten Referenz-Reaktionssignals eine Referenz-Verstärkung des Reaktionssignalpfads zu bestimmen, unter Verwendung der ersten Referenz-Amplitude, der Referenz-Verstärkung und der bestimmten Verstärkung über den Reaktionssignalpfad den Verstärkungskorrekturfaktor zu bestimmen.

Der Verstärkungskorrekturfaktor ist als Formel ausgeschrieben:

$$\text{Verstärkungskorrekturfaktor} = \frac{\text{Referenz} - \text{Verstärkung}}{(\text{Verstärkung}) \cdot (\text{Referenz} - \text{Amplitude})}$$

Das Referenz-Anregungssignal ist dabei vorzugsweise ein Mess-Anregungssignal wie zum Beispiel ein CPMG-Anregungssignal. Ein CPMG-Anregungssignal weist eine Carr-Purcell-Meiboom-Gill-Pulsfolge auf. Das Medium ist vorzugsweise stillstehend und weist keine schnellen Komponenten auf. Ein solches Medium ist zum Beispiel demineralisiertes Wasser mit Kupfersulfat ($CuSO_4$).

Nachdem bereits erkannt worden ist, dass die Verstärkung über den Reaktionssignalpfad eine instabile erste Eigenschaft ist, ist darüber hinaus erkannt worden, dass eine instabile zweite Eigenschaft eine magnetische Flussdichte im Medium ist. Allgemein wird die magnetische Flussdichte im Medium durch ein von der Generatoreinrichtung erzeugtes Anregungssignal hervorgerufen. Somit wird diese magnetische Flussdichte nicht durch die Magnetisierungsvorrichtung bewirkt. Die magnetische Flussdichte ist in dem Sinn instabil als das ein bestimmtes Anregungssignal bei mehrfacher Übertragung auf das Medium unterschiedliche magnetische Flussdichten bewirkt. Ursache hierfür sind Schwankungen der Eigenschaften des Messsignalpfads, insbesondere des Anregungssignalpfads.

Deshalb ist in einer weiteren Ausgestaltung des erfindungsgemäßen kernmagnetischen Messgeräts vorgesehen, dass die Steuerungseinrichtung ausgebildet ist, die zweite Eigenschaft des Messsignalpfads zu bestimmen, indem die Steuerungseinrichtung zunächst den ersten Wechselschalter in den ersten Schaltzustand und den zweiten Wechselschalter in den zweiten Schaltzustand bringt und dann ein zweites Test-Anregungssignal erzeugt, ein vom zweiten Test-Anregungssignal hervorgerufenes zweites Test-Reaktionssignal empfängt und unter Verwendung des zweiten Test-Anregungssignals und des zweiten Test-Reaktionssignals die magnetische Flussdichte im Medium, als die zweite Eigenschaft bestimmt.

Wenn der erste Wechselschalter im ersten Schaltzustand und der zweite Wechselschalter im zweiten Schaltzustand sind, dann ist der Teil des Reaktionssignalpfads durch den Umgehungssignalpfad umgangen, der sich von der Übertragungseinrichtung bis zum zweiten Wechselschalter erstreckt. In diesem Teil des Reaktionssignalpfads liegt insbesondere die zweite Konditionierungseinrichtung. Die Generatoreinrichtung ist ausgebildet, das zweite Test-Anregungssignal als Anregungssignal zu erzeugen. Das Test-Anregungssignal ist zum Beispiel ein Mess-Anregungssignal oder ein Teil von einem Mess-Anregungssignal. Das von der Generatoreinrichtung erzeugte zweite Test-Anregungssignal bereitet sich über den Anregungssignalpfad durch den ersten Wechselschalter, die erste Konditionierungseinrichtung und die Antenneneinrichtung bis hinein in das Medium aus. Das Test-Anregungssignal ruft im Medium das zweite Test-Reaktionssignal hervor, wobei das zweite Test-Reaktionssignal Informationen über die magnetische Flussdichte im Medium aufweist. Das zweite Test-Reaktionssignal bereitet sich über den Reaktionssignalpfad zur Übertragungseinrichtung aus. Die Übertragungseinrichtung überträgt das Test-Reaktionssignal vom Reaktionssignalpfad auf den Umgehungssignalpfad. Weiter bereitet sich das Testreaktionssignal über den Umgehungssignalpfad durch den zweiten Wechselschalter bis zur Empfangseinrichtung aus. Durch die Umgehung des beschriebenen Teils des Reaktionssignalpfads ist das Test-Reaktionssignal durch instabile Eigenschaften insbesondere der zweiten Konditionierungseinrichtung unbeeinflusst, wodurch das Testreaktionssignal an der Empfangseinrichtung dem an der Übertragungseinrichtung entspricht. Das Test-Reaktionssignal wird somit nur durch instabile Eigenschaften des Anregungssignalpfads beeinflusst, wozu insbesondere instabile Eigenschaften der ersten Konditionierungseinrichtung und des Mediums gehören. Die Empfangseinrichtung ist ausgebildet, das zweite Test-Reaktionssignal als Reaktionssignal zu empfangen. Somit ist in dem Test-Anregungssignal und in dem Test-Reaktionssignal zusammen genommen die Information über die magnetische Flussdichte im Medium enthalten. Erfindungsgemäß ist erkannt worden, dass die auf diese Weise bestimmte magnetische Flussdichte einer im Medium durch ein Anregungssignal erzeugten magnetischen Flussdichte entspricht.

In einer Weiterbildung der vorangehenden Ausgestaltung ist vorgesehen, dass die Steuerungseinrichtung ausgebildet ist, die magnetische Flussdichte über ein Intervall zu integrieren. Das Integral der magnetischen Flussdichte ist dabei ein Maß für den Winkel zwischen dem Vektor des makroskopischen Magnetfelds, welches durch die Magnetisierungsvorrichtung erzeugt wird, und dem Vektor der präzisierenden Magnetisierung des Mediums, welche durch das zweite Test-Anregungssignal erzeugt wird und die magnetische Flussdichte bewirkt. Da dieser Winkel nicht nur vom Betrag der magnetischen Flussdichte, sondern auch von der Beschaffenheit des zweiten Test-Anregungssignals abhängt, ist die zweite Eigenschaft genauer bestimmt. Zur Beschaffenheit des zweiten Test-Anregungssignals gehören insbesondere die Dauer und der zeitliche Verlauf des zweiten Test-Anregungssignals.

Wenn die Steuerungseinrichtung ausgebildet ist, neben der kernmagnetischen Messung auch mindestens eine Bestimmung der zweiten Eigenschaft auszuführen, gibt es mehrere Ausgestaltungen für die zeitliche Abfolge der Ausführung der mindestens einen Bestimmung der zweiten Eigenschaft und der Ausführung der kernmagnetischen Messung. Im Betrieb des kernmagnetischen Messgeräts führt die Steuerungseinrichtung Entsprechendes aus.

In einer diesbezüglichen Ausgestaltung ist vorgesehen, dass die Steuerungseinrichtung ausgebildet ist, mindestens eine Bestimmung der zweiten Eigenschaft außerhalb der Ausführung der kernmagnetischen Messung auszuführen. Somit besteht zwischen der Ausführung der mindestens einen Bestimmung der zweiten Eigenschaft und der Ausführung der kernmagnetischen Messung ein zeitlicher Abstand. Durch den zeitlichen Abstand erfolgen die jeweiligen Ausführungen sequenziell, weshalb diese Ausgestaltung auf einfache Weise in der Messvorrichtung zu implementieren ist.

In einer weiteren diesbezüglichen Ausgestaltung ist vorgesehen, dass die Steuerungseinrichtung ausgebildet ist, die mindestens eine Bestimmung der zweiten Eigenschaft während der Ausführung der kernmagnetischen Messung auszuführen und das Mess-Anregungssignal der kernmagnetischen Messung als das zweite Test-Anregungssignal zu verwenden. Während der Ausführung der kernmagnetischen Messung wird von der Generatoreinrichtung das Mess-Anregungssignal erzeugt, welches zumindest einen RF-Puls umfasst. Dieser RF-Puls ist zum Beispiel ein Aktivierungspuls. Weist das Mess-Anregungssignal weitere RF-Pulse auf, so ist einer der weiteren RF-Pulse zum Bespiel ein Refokussierungspuls. Vorzugsweise wird der Aktivierungspuls und/oder Refokussierungspuls als das zweite Test-Anregungssignal verwendet. Diese Ausgestaltung reduziert den Zeitbedarf für die Ausführung der mindestens einen Bestimmung der zweiten Eigenschaft und der Ausführung der kernmagnetischen Messung. Jedoch ist die Implementierung dieser Ausgestaltung in der Steuerungseinrichtung aufwendiger als die Implementierung der vorangehenden Ausgestaltung.

Wenn die Steuerungseinrichtung im Betrieb mehrere Bestimmungen der zweiten Eigenschaft ausführt, so können diese Bestimmungen nicht nur entweder außerhalb oder während der Ausführung der kernmagnetischen Messung ausgeführt werden, sondern können auch beliebige Kombinationen von Ausführungen der Bestimmung der zweiten Eigenschaft außerhalb und während der Ausführung der kernmagnetischen Messung ausgeführt werden. Gleiches trifft auch für eine Kombination von Ausführungen von Bestimmungen der ersten Eigenschaft und der zweiten Eigenschaft zu.

Wenn die Steuerungseinrichtung ausgebildet ist, die zweite Eigenschaft des Messsignalpfads zu bestimmen, dann ist es vorteilhaft, die Steuerungseinrichtung weiter auszubilden, mindestens eine erste und eine zweite Bestimmung der zweiten Eigenschaft auszuführen und eine Interpolation der zweiten Eigenschaft zwischen der mindestens ersten und zweiten Bestimmung der zweiten Eigenschaft durchzuführen. Die Interpolation ermöglicht eine Bestimmung der zweiten Eigenschaft auch zeitlich zwischen der mindestens ersten und zweiten Bestimmung der zweiten Eigenschaft.

Zur Kompensation oder zumindest Reduktion von Schwankungen der magnetischen Flussdichte im Medium, also der zweiten Eigenschaft, ist es vorteilhaft, einen idealen 90°-Puls zu bestimmen. Der ideale 90°-Puls zeichnet sich dadurch aus, dass Schwankungen in den Eigenschaften des Messsignalpfads, insbesondere des Anregungssignalpfads, berücksichtigt sind, sodass eine Abweichung von einer Drehung um 90° um eine Achse der Magnetisierung des Mediums durch den idealen 90°-Puls als Anregungssignal geringer ist als die Abweichung durch einen gewöhnlichen 90°-Puls.

Deshalb ist in einer Ausgestaltung des kernmagnetischen Messgeräts vorgesehen, dass die Steuerungseinrichtung ausgebildet ist, zunächst den ersten und den zweiten Wechselschalter jeweils in den ersten Schaltzustand zu bringen und dann ein zweites Referenz-Anregungssignal zu erzeugen, ein vom zweiten Referenz-Anregungssignal hervorgerufenes zweites Referenz-Reaktionssignal zu empfangen, unter Verwendung des zweiten Referenz-Anregungssignals und des zweiten Referenz-Reaktionssignals einen Referenz-90°-Puls und eine magnetische Referenz-Flussdichte zu bestimmen und unter Verwendung des Referenz-90°-Pulses, der magnetischen Referenz-Flussdichte und der magnetischen Flussdichte den idealen 90°-Puls zu bestimmen. Der Referenz-90°-Puls bewirkt eine Drehung der Magnetisierung des Mediums um genau 90°. Alternativ oder zusätzlich ist die Steuerungseinrichtung ausgebildet, Gleiches für einen 180°-Puls zu bestimmen. Ein Parameter von RF-Pulsen ist ihre jeweilige Dauer, wobei über die Dauer der Betrag der Drehung der Magnetisierung des Mediums einstellbar ist. So beträgt zum Beispiel bei einer ersten Dauer die Drehung 90° und bei einer zweiten Dauer 180°. Diese Pulse bieten sich an, da sie oftmals in Anregungssignalen wie zum Beispiel Aktivierungspulsen und Refokussierungspulsen Anwendung finden.

Der ideale 90°-Puls ist als Formel ausgeschrieben:

$$\text{idealer } 90°\text{-Puls} = \frac{(\text{Referenz - }90°\text{-Puls}) \cdot (\text{magnetische Referenz - Flussdichte})}{\text{magnetische Flussdichte}}$$

Das Referenz-Anregungssignal ist dabei vorzugsweise ein Mess-Anregungssignal wie zum Beispiel ein P90CPMG-Anregungssignal. Ein solches Anregungssignal weist zumindest einen 90°-Puls auf. Das Medium ist vorzugsweise stillstehend. Ein solches Medium ist zum Beispiel demineralisiertes Wasser mit Kupfersulfat.

In einer weiteren Ausgestaltung des kernmagnetischen Messgeräts ist vorgesehen, dass die Steuerungseinrichtung ausgebildet ist, eine dritte Eigenschaft des Messsignalpfads zu bestimmen, indem die Steuerungseinrichtung zunächst sowohl den ersten Wechselschalter als auch den zweiten Wechselschalter in den jeweils zweiten Schaltzustand bringt und dann ein drittes Test-Anregungssignal erzeugt, ein vom dritten Test-Anregungssignal hervorgerufenes drittes Test-Reaktionssignal empfängt und unter Verwendung des dritten Test-Anregungssignals und des dritten Test-Reaktionssignals eine Übertragungsfunktion des Umgehungssignalpfads, als die dritte Eigenschaft bestimmt. Vorzugsweise ist die Steuerungseinrichtung ausgebildet, eine Genauigkeit der Bestimmung einer instabilen Eigenschaft wie zum Beispiel der ersten Eigenschaft und/oder der zweiten Eigenschaft unter Verwendung der dritten Eigenschaft zu vergrößern. Denn nicht nur der Messsignalpfad hat keine idealen Übertragungseigenschaften, sondern auch der Umgehungssignalpfad. Diese nicht idealen Eigenschaften des Umgehungssignalpfads sind in der Übertragungsfunktion enthalten und können nach deren Bestimmung berücksichtigt werden. Werden die nicht idealen Eigenschaften des Umgehungssignalpfads nicht berücksichtigt, beeinträchtigen diese die Genauigkeit der Bestimmung einer instabilen Eigenschaft.

In einer weiteren Ausgestaltung ist vorgesehen, dass die Übertragungseinrichtung eine galvanische Trennung aufweist. Durch die galvanische Trennung erfolgt die bidirektionale Übertragung von Signalen zwischen dem Umgehungssignalpfad und dem Antennensignalpfad galvanisch getrennt voneinander.

In einer Weiterbildung der vorangehenden Ausgestaltung ist vorgesehen, dass die galvanische Trennung durch einen Lufttransformator umgesetzt ist. In einer zur vorangehenden Weiterbildung alternativen Weiterbildung ist vorgesehen, dass die galvanische Trennung durch einen ersten Lufttransformator zur Übertragung von Signalen vom Umgehungssignalpfad zum Antennensignalpfad und durch einen zweiten Lufttransformator zur Übertragung von Signalen vom Antennensignalpfad zum Umgehungssignalpfad umgesetzt ist.

Im Einzelnen ist eine Vielzahl von Möglichkeiten gegeben, das kernmagnetische Messgerät auszugestalten und weiterzubilden. Dazu wird verwiesen sowohl auf die dem unabhängigen Patentanspruch nachgeordneten Patentansprüche als auch auf die nachfolgende Beschreibung eines bevorzugten Ausführungsbeispiels in Verbindung mit der Zeichnung. In der Zeichnung zeigt:

Fig. 1 ein Ausführungsbeispiel eines kernmagnetischen Messgeräts,

Fig. 2 eine Messvorrichtung des kernmagnetischen Messgeräts,

Fig. 3a und 3b zwei Ausführungsbeispiele einer Übertragungseinrichtung der Messvorrichtung,

Fig. 4a bis 4d eine Abfolge von Signalen, die von der Messvorrichtung erzeugt und empfangen werden,

Fig. 5a bis 5d eine weitere Abfolge von Signalen, die von der Messvorrichtung erzeugt und empfangen werden und

Fig. 6a bis 6d noch eine weitere Abfolge von Signalen, die von der Messvorrichtung erzeugt und empfangen werden.

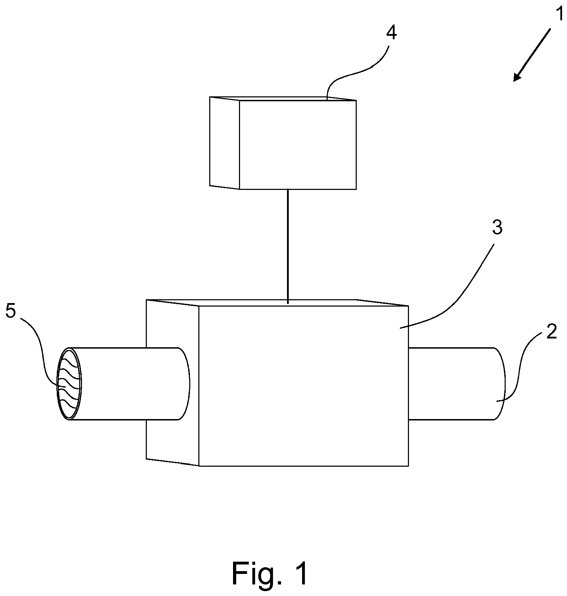

Fig. 1 zeigt in einer abstrahierten perspektivischen Darstellung das kernmagnetische Messgerät 1, welches in diesem Ausführungsbeispiel als kernmagnetisches Durchflussmessgerät ausgestaltet ist. Das kernmagnetische Messgerät 1 weist das Messrohr 2, die Magnetisierungsvorrichtung 3 und die Messvorrichtung 4 auf. Da das kernmagnetische Messgerät 1 in Betrieb ist, ist das Medium 5 im Messrohr 2 vorhanden und magnetisiert die Magnetisierungsvorrichtung 3 das im Messrohr 2 vorhandene Medium 5, sodass an dem Medium 5 kernmagnetische Messungen durch die Messvorrichtung 4 durchführbar sind.

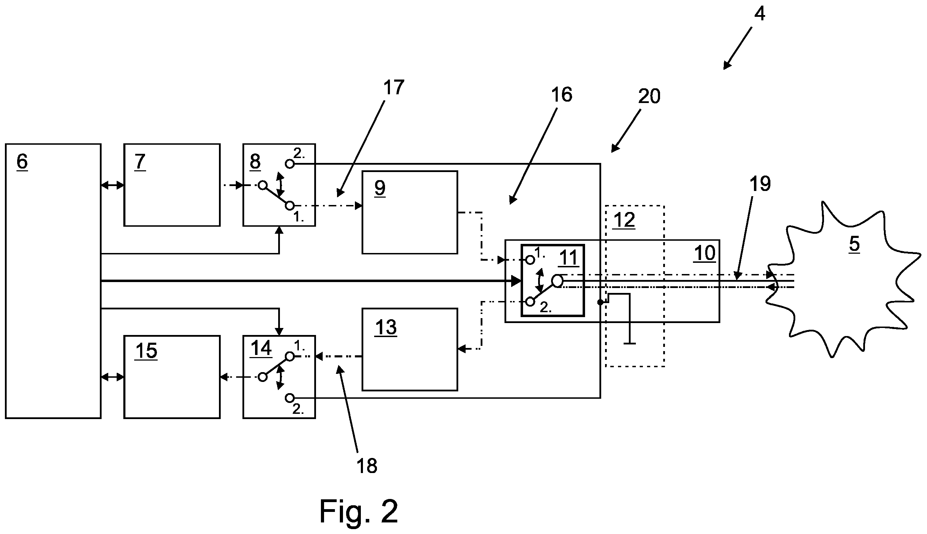

Fig. 2 zeigt wesentliche Komponenten der Messvorrichtung 4 in einem Blockdiagramm. Die Messvorrichtung 4 weist die Steuerungseinrichtung 6, die Generatoreinrichtung 7, den ersten Wechselschalter 8, die erste Konditionierungseinrichtung 9, die Antenneneinrichtung 10 mit dem Wechselschalter 11, die Übertragungseinrichtung 12, die zweite Konditionierungseinrichtung 13, den zweiten Wechselschalter 14, und die Empfangseinrichtung 15 auf.

Weiter weist die Messvorrichtung 4 den Messsignalpfad 16 auf, welcher den Anregungssignalpfad 17 und den Reaktionssignalpfad 18 umfasst. Der Anregungssignalpfad 17 ist als Strichpunktlinie und der Reaktionssignalpfad 18 ist als Strichzweipunktlinie dargestellt. Darüber hinaus weist die Messvorrichtung 4 noch den Antennensignalpfad 19 auf, wobei der Anregungssignalpfad 17 und der Reaktionssignalpfad 18 im Antennensignalpfad 19 zusammenfallen. Weiter weist die Messvorrichtung 4 noch den Umgehungssignalpfad 20 auf. Der Umgehungssignalpfad 20 und die Übertragungseinrichtung 12 sind miteinander verbunden und die Übertragungseinrichtung 12 ist zur bidirektionalen Übertragung von Signalen zwischen dem Umgehungssignalpfad 20 und dem Antennensignalpfad 19 ausgebildet.

Die Generatoreinrichtung 7 ist zur Erzeugung von Anregungssignalen, die erste Konditionierungseinrichtung 9 zur Konditionierung der Anregungssignale und die Antenneneinrichtung 10 zur Übertragung der konditionierten Anregungssignale auf das Medium 5 ausgebildet. Weiter ist die Antenneneinrichtung 10 zur Detektion von durch die Anregungssignale im Medium 5 hervorgerufenen Reaktionssignalen, die zweite Konditionierungseinrichtung 13 zur Konditionierung der Reaktionssignale und die Empfangseinrichtung 14 zum Empfangen der konditionierten Reaktionssignale ausgebildet. Die Generatoreinrichtung 7 weist zur Erzeugung der Anregungssignale einen Digital-Analog-Umsetzer, die erste Konditionierungseinrichtung 9 zur Konditionierung der Anregungssignale einen Leistungsverstärker, die Antenneneinrichtung 10 zur Übertragung der Anregungssignale auf das Medium 5 und zur Detektion der Reaktionssignale eine Spuleneinrichtung, die zweite Konditionierungseinrichtung 13 zur Konditionierung der Reaktionssignale einen Verstärker für schwache Signale und die Empfangseinrichtung 15 zum Empfangen der Reaktionssignale einen Analog-Digital-Umsetzer auf.

Der erste Wechselschalter 9 ist derart angeordnet, dass in einem ersten Schaltzustand die Generatoreinrichtung 7 mit dem Anregungssignalpfad 17 und in einem zweiten Schaltzustand die Generatoreinrichtung 7 mit dem Umgehungssignalpfad 20 verbunden ist. Der zweite Wechselschalter 14 ist derart angeordnet, dass in einem ersten Schaltzustand die Empfangseinrichtung 15 mit dem Reaktionssignalpfad 18 und in einem zweiten Schaltzustand die Empfangseinrichtung 15 mit dem Umgehungssignalpfad 20 verbunden ist. Der Antennenwechselschalter 11 verbindet in einem ersten Schaltzustand den Antennensignalpfad 19 mit dem Anregungssignalpfad 17 und verbindet in einem zweiten Schaltzustand den Antennensignalpfad 19 mit dem Reaktionssignalpfad 18. Somit führt der Antennensignalpfad sowohl die Anregungssignale als auch die Empfangssignale und fallen in diesem Sinne der Anregungssignalpfad 17 und der Reaktionssignalpfad 18 im Antennensignalpfad 19 zusammen.

Die Steuerungseinrichtung 6 ist zur Steuerung der Generatoreinrichtung 7, der Empfangseinrichtung 15, des ersten Wechselschalters 8, des zweiten Wechselschalters 14 und des Antennenwechselschalters 11 ausgebildet, was in Fig. 2 durch Pfeile symbolisiert ist.

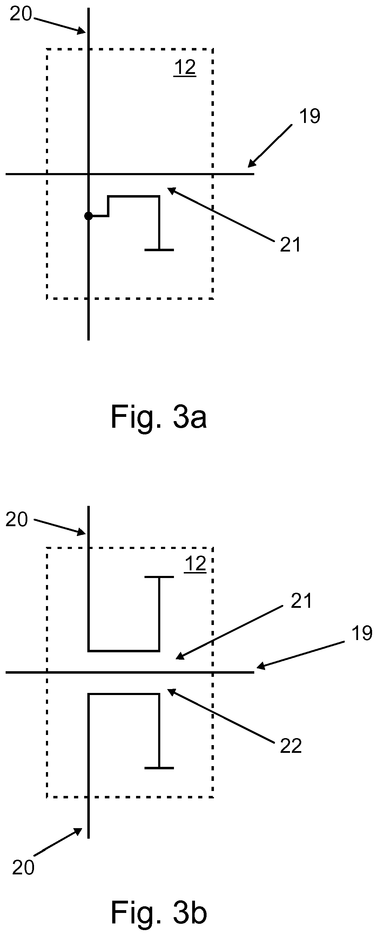

Fig. 3a ist ein Ausschnitt von Fig. 2 und zeigt die Übertragungseinrichtung 12. Die Übertragungseinrichtung 12 weist eine galvanische Trennung auf, sodass die bidirektionale Übertragung von Signalen zwischen dem Umgehungssignalpfad 20 und dem Antennensignalpfad 19 galvanisch getrennt erfolgt. Die galvanische Trennung wird durch den ersten Lufttransformator 21 umgesetzt. Der erste Lufttransformator 21 koppelt den Umgehungssignalpfad 20 und den Antennensignalpfad 19 induktiv miteinander. Der erste Lufttransformator 21 überträgt Signale bidirektional zwischen dem Umgehungssignalpfad 20 und dem Antennensignalpfad 19.

Fig. 3b zeigt eine alternative Ausgestaltung der in Fig. 3a gezeigten Übertragungseinrichtung 12. Bei der alternativen Ausgestaltung ist der Umgehungssignalpfad 20 elektrisch in zwei Abschnitte aufgetrennt und weist die Übertragungseinrichtung 12 neben den ersten Lufttransformator 21 noch den zweiten Lufttransformator 22 auf. Der erste Lufttransformator 21 koppelt den einen Abschnitt des Umgehungssignalpfads 20 und den Antennensignalpfad 19 zur Übertragung von Signalen vom Umgehungssignalpfad 20 auf den Antennensignalpfad 19 induktiv miteinander und der zweite Lufttransformator 22 koppelt den anderen Abschnitt des Umgehungssignalpfads 20 und den Antennensignalpfad 19 zur Übertragung von Signalen vom Antennensignalpfad 19 auf den Umgehungssignalpad 20 induktiv miteinander. Durch den ersten Lufttransformator 21 und den zweiten Lufttransformator 22 erfolgt die Übertragung von Signalen zwischen dem Umgehungssignalpfad 20 und dem Antennensignalpfad 19 galvanisch getrennt.

Wenn die Steuerungseinrichtung 6 in Fig. 2 den ersten Wechselschalter 8 in den ersten Schaltzustand und den Antennenwechselschalter 11 in den ersten Schaltzustand gebracht und die Generatoreinrichtung 7 zur Erzeugung von Anregungssignalen angesteuert hat, dann führt der Anregungssignalpfad 17 die Anregungssignale von der Generatoreinrichtung 7 über den ersten Wechselschalter 8, über die erste Konditionierungseinrichtung 9, über den Antennenwechselschalter 11 und über die Antenneneinrichtung 10 auf das Medium 5. Wenn die Steuerungseinrichtung 6 den zweiten Wechselschalter 14 in den ersten Schaltzustand und den Antennenwechselschalter 11 in den zweiten Schaltzustand gebracht hat und die Empfangseinrichtung 15 zum Empfang von Reaktionssignalen eingestellt hat, dann führt der Reaktionssignalpfad 18 Reaktionssignale vom Medium 5 über die Antenneneinrichtung 10, über den Antennenwechselschalter 11, über die zweite Konditionierungseinrichtung 13 und über den zweiten Wechselschalter 14 zur Empfangseinrichtung 15.

Die Steuerungseinrichtung 6 ist ausgebildet, eine kernmagnetische Messung durchzuführen, indem die Steuerungseinrichtung 6 zunächst den ersten Wechselschalter 8 und den zweiten Wechselschalter 14 jeweils in den ersten Schaltzustand bringt. Danach bringt die Steuerungseinrichtung 6 den Antennenwechselschalter 11 in den ersten Schaltzustand, erzeugt dann ein Mess-Anregungssignal, bringt dann den Antennenwechselschalter 11 vom ersten in den zweiten Schaltzustand, empfängt dann ein vom Mess-Anregungssignal hervorgerufenes Mess-Reaktionssignal und bestimmt unter Verwendung des Mess-Anregungssignals und des Mess-Reaktionssignals eine Information über das Medium.

Wenn die Steuerungseinrichtung 6 den ersten Wechselschalter 8 in den zweiten Schaltzustand und den zweiten Wechselschalter 14 in den ersten Schaltzustand gebracht hat, dann ist der Teil des Anregungssignalpfads 17 durch den Umgehungssignalpfad 20 umgangen, der sich vom ersten Wechselschalter 8 bis zur Übertragungseinrichtung 12 erstreckt. In diesem Teil des Anregungssignalpfads 17 liegt insbesondere die erste Konditionierungseinrichtung 9. Wenn die Steuerungseinrichtung 6 den ersten Wechselschalter 8 in den ersten Schaltzustand und den zweiten Wechselschalter 14 in den zweiten Schaltzustand gebracht hat, dann ist der Teil des Reaktionssignalpfads 18 durch den Umgehungssignalpfad 20 umgangen, der sich von der Übertragungseinrichtung 12 bis zum zweiten Wechselschalter 14 erstreckt. In diesem Teil des Reaktionssignalpfads 18 liegt insbesondere die zweite Konditionierungseinrichtung 13. Demnach ist die Steuerungseinrichtung 6 ausgebildet, den ersten Wechselschalter 8 und den zweiten Wechselschalter 14 anzusteuern, sodass ein Teil des Messsignalpfads 16 durch den Umgehungssignalpfad 20 umgangen ist.

Die Steuerungseinrichtung 6 ist ausgebildet, dann, wenn durch den Umgehungssignalpfad 20 ein Teil des Messsignalpfads 16 umgangen ist, mit der Generatoreinrichtung 7 ein Test-Anregungssignal zu erzeugen, ein vom Test-Anregungssignal hervorgerufenes Test-Reaktionssignal mit der Empfangseinrichtung 15 zu empfangen, unter Verwendung des Test-Anregungssignals und des Test-Reaktionssignals eine Eigenschaft des Messsignalpfads 16 zu bestimmen und eine Genauigkeit einer Information über das Medium 5 aus einer kernmagnetischen Messung unter Verwendung der Eigenschaft des Messsignalpfads zu erhöhen.

In diesem Ausführungsbeispiel ist die Steuerungseinrichtung 6 ausgebildet, eine erste und eine zweite Eigenschaft des Messsignalpfads 16 zu bestimmen und zur Erhöhung der Genauigkeit einer Informationen über das Medium 5 zu verwenden.

Bei der ersten Eigenschaft des Messsignalpfads 16 handelt es sich um eine Verstärkung über den Reaktionssignalpfad 18. Diese wird bestimmt, indem die Steuerungseinrichtung 6 zunächst den ersten Wechselschalter 8 in den zweiten Schaltzustand und den zweiten Wechselschalter 14 in den ersten Schaltzustand bringt und dann ein erstes Test-Anregungssignal erzeugt, ein vom ersten Test-Anregungssignal hervorgerufenes erstes Test-Reaktionssignal empfängt und unter Verwendung des ersten Test-Anregungssignals und des ersten Test-Reaktionssignals die Verstärkung bestimmt.

Bei der zweiten Eigenschaft des Messsignalpfads 16 handelt es sich um eine magnetische Flussdichte im Medium 5. Diese wird bestimmt, indem die Steuerungseinrichtung 6 zunächst den ersten Wechselschalter 8 in den ersten Schaltzustand und den zweiten Wechselschalter 14 in den zweiten Schaltzustand bringt und dann ein zweites Test-Anregungssignal erzeugt, ein vom zweiten Test-Anregungssignal hervorgerufenes zweites Test-Reaktionssignal empfängt und unter Verwendung des zweiten Test-Anregungssignals und des zweiten Test-Reaktionssignals die magnetische Flussdichte im Medium 5 bestimmt.

Die Steuerungseinrichtung 6 ist ausgebildet, im Betrieb die Bestimmung der Verstärkung und/oder die Bestimmung der magnetischen Flussdichte während und/oder außerhalb einer Ausführung einer kernmagnetischen Messung auszuführen.

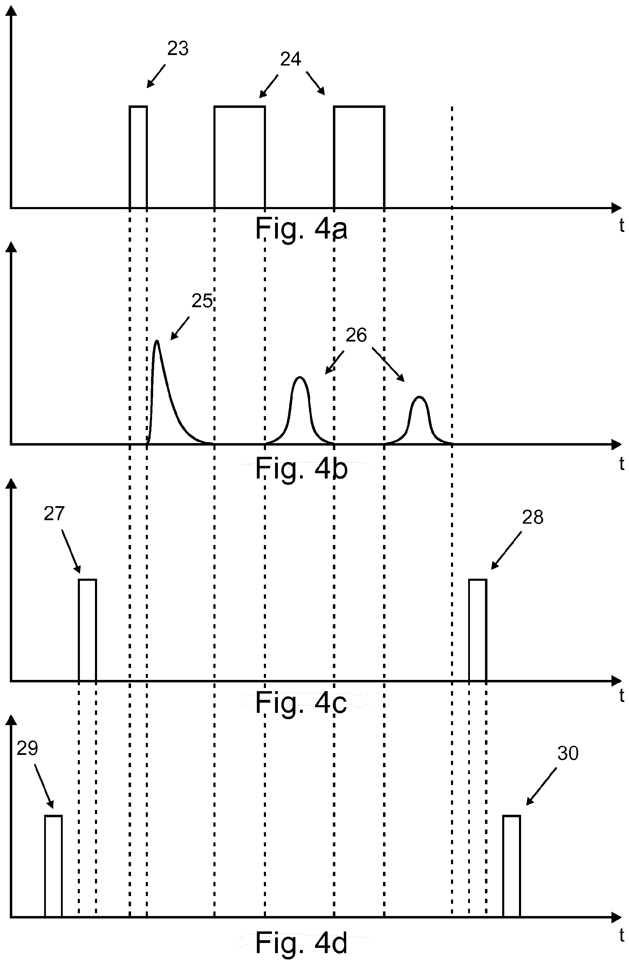

Die Fig. 4a bis 4d zeigen dazu ein erstes Ausführungsbeispiel. Die Figuren 4a und 4b zeigen die Ausführung einer kernmagnetischen Messung. Darin zeigt Fig. 4a als Mess-Anregungssignal den Aktivierungspuls 23 und die zwei Refokussierungspulse 24 und Fig. 4b als Mess-Reaktionssignal den freien Induktionszerfall 25 und die beiden Echosignale 26.

Fig. 4c zeigt die erste Ausführung 27 und die zweite Ausführung 28 der Bestimmung der Verstärkung des Reaktionssignalpfads 18. Die erste Ausführung 27 liegt zeitlich vor und die zweite Ausführung 28 zeitlich nach der Ausführung der kernmagnetischen Messung. Somit erfolgen die erste Ausführung 27 und die zweite Ausführung 28 der Bestimmung der Verstärkung des Reaktionssignalpfads 18 außerhalb der Ausführung der kernmagnetischen Messung.

Fig. 4d zeigt die erste Ausführung 29 und die zweite Ausführung 30 der Bestimmung der magnetischen Flussdichte des Mediums 5. Die erste Ausführung 29 liegt zeitlich vor und die zweite Ausführung 30 zeitlich nach der Ausführung der kernmagnetischen Messung. Somit erfolgen die erste Ausführung 29 und die zweite Ausführung 30 der Bestimmung magnetischen Flussdichte des Mediums 5 außerhalb der Ausführung der kernmagnetischen Messung. Weiterhin erfolgt die erste Ausführung 29 der Bestimmung der magnetischen Flussdichte des Mediums 5 zeitlich vor der ersten Ausführung 27 der Bestimmung der Verstärkung des Reaktionssignalpfads 18 und die zweite Ausführung 30 der Bestimmung der magnetischen Flussdichte des Mediums 5 zeitlich mach der zweiten Ausführung 28 der Bestimmung der Verstärkung des Reaktionssignalpfads 18. Grund hierfür ist, dass die Ausführung der Bestimmung der magnetischen Flussdichte des Mediums 5 eine kernmagnetische Messung beeinflusst, weshalb ein zeitlicher Abstand notwendig ist.

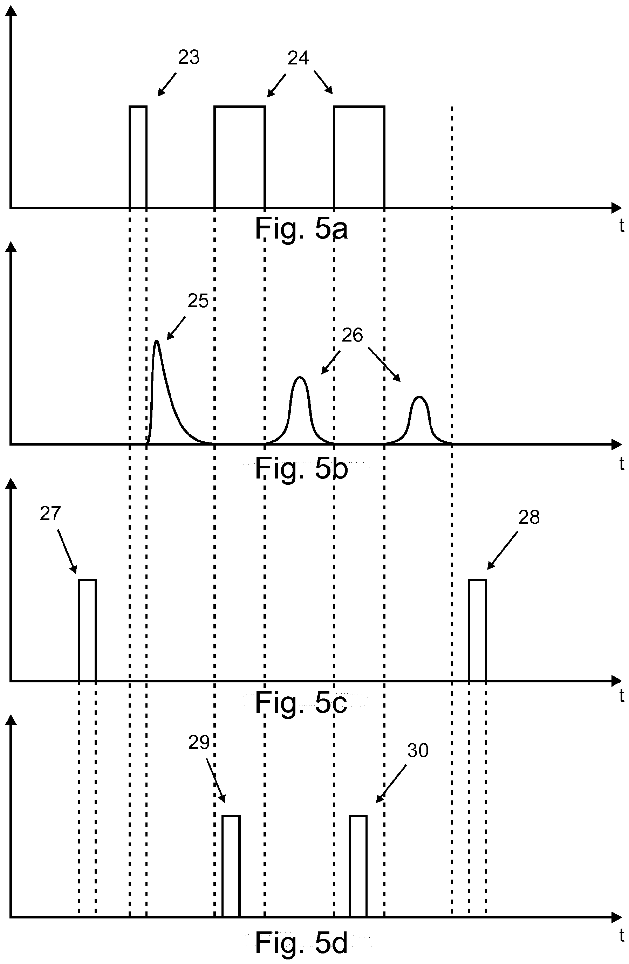

Die Fig. 5a bis 5d zeigen ein zweites Ausführungsbeispiel. Die Fig. 5a und 5b zeigen die Ausführung einer bereits aus den Fig. 4a und 4b bekannten kernmagnetischen Messung.

Fig. 5c zeigt die erste Ausführung 27 und die zweite Ausführung 28 der Bestimmung der Verstärkung des Reaktionssignalpfads 18. Die erste Ausführung 27 liegt zeitlich vor und die zweite Ausführung 28 zeitlich nach der Ausführung der kernmagnetischen Messung. Somit erfolgen die erste Ausführung 27 und die zweite Ausführung 28 der Bestimmung der Verstärkung des Reaktionssignalpfads 18 außerhalb der Ausführung der kernmagnetischen Messung.

Fig. 5d zeigt die erste Ausführung 29 und die zweite Ausführung 30 der Bestimmung der magnetischen Flussdichte des Mediums 5. Die erste Ausführung 29 und die zweite Ausführung 30 erfolgen während der Ausführung der kernmagnetischen Messung, und zwar werden die Refokussierungspulse 24 als zweite Test-Anregungssignale verwendet. Durch die Verwendung der Refokussierungspulse 24 als zweite Test-Anregungssignale erfolgt keine Beeinflussung der kernmagnetischen Messung durch die Ausführung der Bestimmung der magnetischen Flussdichte des Mediums 5.

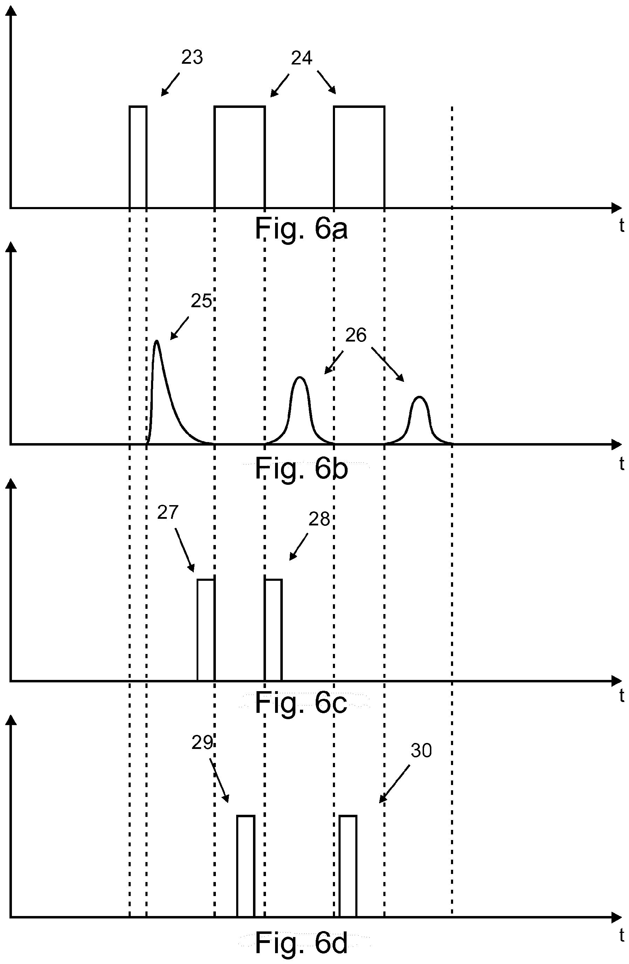

Die Fig. 6a bis 6d zeigen ein drittes Ausführungsbeispiel. Die Fig. 6a und 6b zeigen die Ausführung einer bereits aus den Fig. 4a und 4b bekannten kernmagnetischen Messung.

Fig. 6c zeigt die erste Ausführung 27 und die zweite Ausführung 28 der Bestimmung der Verstärkung des Reaktionssignalpfads 18. Die erste Ausführung 27 und die zweite Ausführung 28 erfolgen während der Ausführung der kernmagnetischen Messung, und zwar während des freien Induktionszerfalls 25 und des ersten der beiden Echosignale 26. Dabei werden Intervalle des freien Induktionszerfalls 25 und des Echosignals 26 verwendet, welche nicht als Mess-Reaktionssignal bei der kernmagnetischen Messung verwendet werden.

Fig. 6d zeigt die erste Ausführung 29 und die zweite Ausführung 30 der Bestimmung der magnetischen Flussdichte des Mediums 5. Die erste Ausführung 29 und die zweite Ausführung 30 erfolgen während der Ausführung der kernmagnetischen Messung, und zwar werden die Refokussierungspulse 24 als zweite Test-Anregungssignale verwendet. Durch die Verwendung der Refokussierungspulse 24 als zweite Test-Anregungssignale erfolgt keine Beeinflussung der kernmagnetischen Messung durch die Ausführung der Bestimmung der magnetischen Flussdichte des Mediums 5.

Während das erste Ausführungsbeispiel im Vergleich zu den beiden anderen Ausführungsbeispielen einfacher in der Steuerungseinrichtung 6 umzusetzen ist, ist die Ausführungszeit des dritten Ausführungsbeispiels im Vergleich zu den beiden anderen Ausführungsbeispielen geringer.

**Bezugszeichen**

| | |
|---|---|
| 1 | Kernmagnetisches Messgerät |
| 2 | Messrohr |
| 3 | Magnetisierungsvorrichtung |
| 4 | Messvorrichtung |
| 5 | Medium |
| 6 | Steuerungseinrichtung |
| 7 | Generatoreinrichtung |
| 8 | Erster Wechselschalter |
| 9 | Erste Konditionierungseinrichtung |
| 10 | Antenneneinrichtung |
| 11 | Antennenwechselschalter |
| 12 | Übertragungseinrichtung |
| 13 | Zweite Konditionierungseinrichtung |
| 14 | Zweiter Wechselschalter |
| 15 | Empfangseinrichtung |
| 16 | Messsignalpfad |
| 17 | Anregungssignalpfad |
| 18 | Reaktionssignalpfad |
| 19 | Antennensignalpfad |
| 20 | Umgehungssignalpfad |
| 21 | Erster Lufttransformator |
| 22 | Zweiter Lufttransformator |
| 23 | Aktivierungspuls |
| 24 | Refokussierungspuls |
| 25 | Freier Induktionszerfall |
| 26 | Echosignal |
| 27 | Erste Ausführung der Bestimmung der ersten Eigenschaft |

28    Zweite Ausführung der Bestimmung der ersten Eigenschaft
29    Erste Ausführung der Bestimmung der zweiten Eigenschaft
30    Zweite Ausführung der Bestimmung der zweiten Eigenschaft

**Patentansprüche**

1.  Kernmagnetisches Messgerät (1) mit einer Messvorrichtung (4) zur Durchführung von kernmagnetischen Messungen an einem Medium (5),
    wobei die Messvorrichtung (4) eine Steuerungseinrichtung (6), eine Generatoreinrichtung (7) zur Erzeugung von Anregungssignalen, eine erste Konditionierungseinrichtung (9) zur Konditionierung der Anregungssignale, eine Antenneneinrichtung (10) zur Übertragung der konditionierten Anregungssignale auf das Medium (5) und zur Detektion von durch die Anregungssignale im Medium (5) hervorgerufenen Reaktionssignalen, eine zweite Konditionierungseinrichtung (13) zur Konditionierung der Reaktionssignale, eine Empfangseinrichtung (15) zum Empfangen der konditionierten Reaktionssignale und einen Messsignalpfad (16) aufweist,
    wobei der Messsignalpfad (16) einen Anregungssignalpfad (17) und einen Reaktionssignalpfad (18) aufweist, der Anregungssignalpfad (17) die Anregungssignale von der Generatoreinrichtung (7) über die erste Konditionierungseinrichtung (9) und die Antenneneinrichtung (10) auf das Medium (5) und der Reaktionssignalpfad (18) die Reaktionssignale vom Medium (5) über die Antenneneinrichtung (10) und die zweite Konditionierungseinrichtung (13) zur Empfangseinrichtung (15) führt,
    wobei die Antenneneinrichtung (10) einen Antennensignalpfad (19) aufweist und der Anregungssignalpfad (17) und der Reaktionssignalpfad (18) im Antennensignalpfad (19) zusammenfallen,
    **dadurch gekennzeichnet,**
    **dass** die Messvorrichtung (4) einen Umgehungssignalpfad (20) und eine Übertragungseinrichtung (12) aufweist, der Umgehungssignalpfad (20) und die Übertragungseinrichtung (12) miteinander verbunden sind und die Übertragungseinrichtung (12) zur bidirektionalen Übertragung von Signalen zwischen dem Umgehungssignalpfad (20) und dem Antennensignalpfad (19) ausgebildet ist,
    **dass** ein erster Wechselschalter (8) derart angeordnet ist, dass in einem ersten Schaltzustand die Generatoreinrichtung (7) mit dem Anregungssignalpfad (17) und in einem zweiten Schaltzustand die Generatoreinrichtung (7) mit dem Umgehungssignalpfad (20) verbunden ist,
    **dass** ein zweiter Wechselschalter (14) derart angeordnet ist, dass in einem ersten Schaltzustand die Empfangseinrichtung (15) mit dem Reaktionssignalpfad (18) und in einem zweiten Schaltzustand die Empfangseinrichtung (15) mit dem Umgehungssignalpfad (20) verbunden ist,
    **dass** die Steuerungseinrichtung (6) ausgebildet ist, zunächst den ersten Wechselschalter (8) und den zweiten Wechselschalter (14) anzusteuern, sodass ein Teil des Messsignalpfads (16) durch den Umgehungssignalpfad (20) umgangen ist, und dann mit der Generatoreinrichtung (7) ein Test-Anregungssignal zu erzeugen, ein vom Test-Anregungssignal hervorgerufenes Test-Reaktionssignal mit der Empfangseinrichtung (15) zu empfangen und unter Verwendung des Test-Anregungssignals und des Test-Reaktionssignals eine Eigenschaft des Messsignalpfads (16) zu bestimmen.

2.  Kernmagnetisches Messgerät (1) nach Anspruch 1, **dadurch gekennzeichnet, dass** die Steuerungseinrichtung (6) ausgebildet ist, eine kernmagnetische Messung auszuführen, indem die Steuerungseinrichtung (6) zunächst den ersten Wechselschalter (8) in den ersten Schaltzustand und den zweiten Wechselschalter (14) in den ersten Schaltzustand bringt und dann ein Mess-Anregungssignal erzeugt, ein vom Mess-Anregungssignal hervorgerufenes Mess-Reaktionssignal empfängt und unter Verwendung des Mess-Anregungssignals und des Mess-Reaktionssignals eine Information über das Medium (5) bestimmt.

3.  Kernmagnetisches Messgerät (1) nach Anspruch 2, **dadurch gekennzeichnet, dass** die Steuerungseinrichtung (6) ausgebildet ist, eine Genauigkeit der Information über das Medium (5) unter Verwendung der Eigenschaft des Messsignalpfads (16) zu erhöhen.

4.  Kernmagnetisches Messgerät (1) nach einem der Ansprüche 1 bis 3, **dadurch gekennzeichnet, dass** die Steuerungseinrichtung (6) ausgebildet ist, eine erste Eigenschaft des Messsignalpfads (16) zu bestimmen, indem die Steuerungseinrichtung (6) zunächst den ersten Wechselschalter (8) in den zweiten Schaltzustand und den zweiten Wechselschalter (14) in den ersten Schaltzustand bringt und dann ein erstes Test-Anregungssignal erzeugt, ein vom ersten Test-Anregungssignal hervorgerufenes erstes Test-Reaktionssignal empfängt und unter Verwendung des ersten Test-Anregungssignals und des ersten Test-Reaktionssignals eine Verstärkung über den Reaktionssignalpfad (18) als die erste Eigenschaft bestimmt.

5. Kernmagnetisches Messgerät (1) nach Anspruch 4 und Anspruch 2 oder 3, **dadurch gekennzeichnet, dass** die Steuerungseinrichtung (6) ausgebildet ist, mindestens eine Bestimmung der ersten Eigenschaft außerhalb der Ausführung der kernmagnetischen Messung auszuführen.

6. Kernmagnetisches Messgerät (1) nach Anspruch 2 oder 3 und nach Anspruch 4 oder 5, **dadurch gekennzeichnet, dass** die Steuerungseinrichtung (6) ausgebildet ist, mindestens eine Bestimmung der ersten Eigenschaft während der Ausführung der kernmagnetischen Messung auszuführen.

7. Kernmagnetisches Messgerät (1) nach einem der Ansprüche 4 bis 6, **dadurch gekennzeichnet, dass** die Steuerungseinrichtung (6) ausgebildet ist, mindestens eine erste und eine zweite Bestimmung der ersten Eigenschaft auszuführen und eine Interpolation der ersten Eigenschaft zwischen der mindestens ersten und zweiten Bestimmung der ersten Eigenschaft durchzuführen.

8. Kernmagnetisches Messgerät (1) nach einem der Ansprüche 4 bis 7, **dadurch gekennzeichnet, dass** die Steuerungseinrichtung (6) ausgebildet ist, zunächst den ersten Wechselschalter (8) in den ersten Schaltzustand und den zweiten Wechselschalter (14) in den ersten Schaltzustand zu bringen und dann ein erstes Referenz-Anregungssignal zu erzeugen, ein vom ersten Referenz-Anregungssignal hervorgerufenes erstes Referenz-Reaktionssignal zu empfangen, eine erste Referenz-Amplitude des ersten Referenz-Reaktionssignals und unter Verwendung des ersten Referenz-Anregungssignals und des ersten Referenz-Reaktionssignals eine Referenz-Verstärkung des Reaktionssignalpfads (18) zu bestimmen, unter Verwendung der ersten Referenz-Amplitude, der Referenz-Verstärkung und der Verstärkung über den Reaktionssignalpfad einen Verstärkungskorrekturfaktor zu bestimmen.

9. Kernmagnetisches Messgerät (1) nach einem der Ansprüche 1 bis 8, **dadurch gekennzeichnet, dass** die Steuerungseinrichtung (6) ausgebildet ist, eine zweite Eigenschaft des Messsignalpfads (16) zu bestimmen, indem die Steuerungseinrichtung (6) zunächst den ersten Wechselschalter (8) in den ersten Schaltzustand und den zweiten Wechselschalter (14) in den zweiten Schaltzustand bringt und dann ein zweites Test-Anregungssignal erzeugt, ein vom zweiten Test-Anregungssignal hervorgerufenes zweites Test-Reaktionssignal empfängt und unter Verwendung des zweiten Test-Anregungssignals und des zweiten Test-Reaktionssignals eine magnetische Flussdichte im Medium (5) als die zweite Eigenschaft bestimmt.

10. Kernmagnetisches Messgerät (1) nach Anspruch 9, **dadurch gekennzeichnet, dass** die Steuerungseinrichtung (6) ausgebildet ist, die magnetische Flussdichte über ein Intervall zu integrieren.

11. Kernmagnetisches Messgerät (1) nach Anspruch 2 oder 3 und nach Anspruch 9 oder 10 und Anspruch 2 oder 3, **dadurch gekennzeichnet, dass** die Steuerungseinrichtung (6) ausgebildet ist, mindestens eine Bestimmung der zweiten Eigenschaft außerhalb der Ausführung der kernmagnetischen Messung auszuführen.

12. Kernmagnetisches Messgerät (1) nach einem der Ansprüche 9 bis 11, **dadurch gekennzeichnet, dass** die Steuerungseinrichtung (6) ausgebildet ist, mindestens eine Bestimmung der zweiten Eigenschaft während der Ausführung der kernmagnetischen Messung auszuführen und das Mess-Anregungssignal als das zweite Test-Anregungssignal zu verwenden.

13. Kernmagnetisches Messgerät (1) nach einem der Ansprüche 9 bis 12, **dadurch gekennzeichnet, dass** die Steuerungseinrichtung (6) ausgebildet ist, mindestens eine erste Bestimmung und eine zweite Bestimmung der zweiten Eigenschaft auszuführen und eine Interpolation zwischen der mindestens ersten und zweiten Bestimmung der zweiten Eigenschaft durchzuführen.

14. Kernmagnetisches Messgerät (1) nach einem der Ansprüche 9 bis 13, **dadurch gekennzeichnet, dass** die Steuerungseinrichtung (6) ausgebildet ist, zunächst den ersten Wechselschalter (8) in den ersten Schaltzustand und den zweiten Wechselschalter (14) in den ersten Schaltzustand zu bringen und dann ein zweites Referenz-Anregungssignal zu erzeugen, ein vom zweiten Referenz-Anregungssignal hervorgerufenes zweites Referenz-Reaktionssignal zu empfangen, unter Verwendung des zweiten Referenz-Anregungssignals und des zweiten Referenz-Reaktionssignals einen Referenz-90°-Puls und eine magnetische Referenz-Flussdichte zu bestimmen und unter Verwendung des Referenz-90°-Pulses, der magnetischen Referenz-Flussdichte und der magnetischen Flussdichte einen 90°-Puls zu bestimmen.

15. Kernmagnetisches Messgerät (1) nach einem der Ansprüche 1 bis 14, **dadurch gekennzeichnet, dass** die Steuerungseinrichtung (6) ausgebildet ist, eine dritte Eigenschaft des Messsignalpfads (16) zu bestimmen, indem die Steuerungseinrichtung (6) zunächst den ersten Wechselschalter (8) in den zweiten Schaltzustand und den zweiten Wechselschalter (14) in den zweiten Schaltzustand bringt und dann ein drittes Test-Anregungssignal erzeugt, ein vom dritten Test-Anregungssignal hervorgerufenes drittes Test-Reaktionssignal empfängt und unter Verwendung des dritten Test-Anregungssignals und des dritten Test-Reaktionssignals eine Übertragungsfunktion des Umgehungssignalpfads (20) als die dritte Eigenschaft bestimmt.

16. Kernmagnetisches Messgerät (1) nach einem der Ansprüche 1 bis 15, **dadurch gekennzeichnet, dass** die Übertragungseinrichtung (12) eine galvanische Trennung aufweist.

17. Kernmagnetisches Messgerät (1) nach Anspruch 16, **dadurch gekennzeichnet, dass** galvanische Trennung durch einen Lufttransformator (21) umgesetzt ist.

18. Kernmagnetisches Messgerät (1) nach Anspruch 16, **dadurch gekennzeichnet, dass** die galvanische Trennung durch einen ersten Lufttransformator (21) zur Übertragung von Signalen vom Umgehungssignalpfad (20) zum Antennensignalpfad (19) und einen zweiten Lufttransformator (22) für zur Übertragung von Signalen vom Antennensignalpfad (19) zum Umgehungssignalpfad (20) umgesetzt ist.

**Claims**

1. Nuclear magnetic measuring device (1) with a measuring device (4) for carrying out nuclear magnetic measurements of a medium (5),
   wherein the measuring device (4) comprises a control unit (6), a generator unit (7) for generating excitation signals, a first conditioning unit (9) for conditioning the excitation signals, an antenna unit (10) for transmission of the conditioned excitation signals to the medium (5) and for detecting reaction signals caused by the excitation signals in the medium, a second conditioning unit (13) for conditioning the reaction signals, a receiving unit (15) for receiving the conditioned reaction signals and a measuring signal path (16),
   wherein the measuring signal path (16) comprises an excitation signal path (17) and a reaction signal path (18), the excitation signal path (17) leading the excitation signals from the generator unit (7) via the first conditioning unit (9) and the antenna unit (10) to the medium (5) and the reaction signal path (18) leading the reaction signals from the medium (5) via the antenna unit (10) and the second conditioning unit (13) to the receiving unit (15),
   wherein the antenna unit (10) has an antenna signal path (19) and the excitation signal path (17) and the reaction signal path (18) coincide in the antenna signal path (19),
   **characterized in**
   **that** the measuring device (4) has a bypass signal path (20) and a transmission unit (12), the bypass signal path (20) and the transmission unit (12) are connected to one another, and the transmission unit (12) is designed for bidirectional transmission of signals between the bypass signal path (20) and the antenna signal path (19),
   **that** a first changeover switch (8) is arranged such that, in a first switching state, the generator unit (7) is connected to the excitation signal path (17) and, in a second switching state, the generator unit (7) is connected to the bypass signal path (20),
   **that** a second changeover switch (14) is arranged such that, in a first switching state, the receiving unit (15) is connected to the reaction signal path (18) and, in a second switching state, the receiving unit (15) is connected to the bypass signal path (20),
   **that** the control unit (6) is designed to first control the first changeover switch (8) and the second changeover switch (14) such that a part of the measuring signal path (16) is bypassed by the bypass signal path (20) and then to generate a test excitation signal with the generator unit (7), to receive a test reaction signal caused by the test excitation signal with the receiving unit (15), and to determine a property of the measuring signal path (16) using the test excitation signal and the test reaction signal.

2. Nuclear magnetic measuring device (1) according to claim 1, **characterized in that** the control unit (6) is designed to carry out a nuclear magnetic measurement, **in that** the control unit (6) first sets the first changeover switch (8) into the first switching state and the second changeover switch (14) into the first switching state and then generates a measurement excitation signal, receives a measurement reaction signal caused by the measurement excitation signal, and determines information about the medium (5) using the measurement excitation signal and the measurement reaction signal.

3. Nuclear magnetic measuring device (1) according to claim 2, **characterized in that** the control unit (6) is designed to increase an accuracy of the information about the medium (5) using the property of the measuring signal path (16).

**4.** Nuclear magnetic measuring device (1) according to any one of claims 1 to 3, **characterized in that** the control unit (6) is designed to determine a first property of the measuring signal path (16) **in that** the control unit (6) first sets the first changeover switch (8) into the second switching state and the second changeover switch (14) into the first switching state and then generates a first test excitation signal, receives a first test reaction signal caused by the first test excitation signal, and, using the first test excitation signal and the first test reaction signal, determines a gain over the reaction signal path (18) as the first property.

**5.** Nuclear magnetic measuring device (1) according to claim 4 and claim 2 or 3, **characterized in that** the control unit (6) is designed to carry out at least one determination of the first property not during execution of the nuclear magnetic measurement.

**6.** Nuclear magnetic measuring device (1) according to claim 2 or 3 and to claim 4 or 5, **characterized in that** the control unit (6) is designed to carry out at least one determination of the first property during execution of the nuclear magnetic measurement.

**7.** Nuclear magnetic measuring device (1) according to any one of claims 4 to 6, **characterized in that** the control unit (6) is designed to carry out at least a first and a second determination of the first property and to carry out an interpolation of the first property between the at least first and second determination of the first property.

**8.** Nuclear magnetic measuring device (1) according to any one of claims 4 to 7, **characterized in that** the control unit (6) is designed to first set the first changeover switch (8) into the first switching state and the second changeover switch (14) into the first switching state, and then to generate a first reference excitation signal, to receive a first reference reaction signal caused by the first reference excitation signal, to determine a first reference amplitude of the first reference reaction signal, to determine a reference gain of the reaction signal path (18) using the first reference excitation signal and the first reference reaction signal, and to determine a gain correction factor using the first reference amplitude, the reference gain and the gain over the reaction signal path (18).

**9.** Nuclear magnetic measuring device (1) according to any one of claims 1 to 8, **characterized in that** the control unit (6) is designed to determine a second property of the measuring signal path (16) **in that** the control unit (6) first sets the first changeover switch (8) into the first switching state and the second changeover switch (14) into the second switching state, and then generates a second test excitation signal, receives a second test reaction signal caused by the second test excitation signal, and, using the second test excitation signal and the second test reaction signal, determines a magnetic flux density in the medium (5) as the second property.

**10.** Nuclear magnetic measuring device (1) according to claim 9, **characterized in that** the control unit (6) is designed to integrate the magnetic flux density over an interval.

**11.** Nuclear magnetic measuring device (1) according to claim 2 or 3 and to claim 9 or 10 and claim 2 or 3, **characterized in that** the control unit (6) is designed to carry out at least one determination of the second property not during execution of the nuclear magnetic measurement.

**12.** Nuclear magnetic measuring device (1) according to any one of claims 9 to 11, **characterized in that** the control unit (6) is designed to carry out at least one determination of the second property during execution of the nuclear magnetic measurement and to use the measurement excitation signal as second test excitation signal.

**13.** Nuclear magnetic measuring device (1) according to any one of claims 9 to 12, **characterized in that** the control unit (6) is designed to carry out at least a first determination and a second determination of the second property and to carry out an interpolation of the second property between the at least first and second determination of the second property.

**14.** Nuclear magnetic measuring device (1) according to any one of claims 9 to 13, **characterized in that** the control unit (6) is designed to first set the first changeover switch (8) into the first switching state and the second changeover switch (14) into the first switching state, and then to generate a second reference excitation signal, to receive a second reference reaction signal caused by the second reference excitation signal, to determine a reference 90° pulse and reference magnetic flux density using the second reference excitation signal and the second reference reaction signal, and to determine a 90° pulse using the reference 90° pulse, the reference magnetic flux density and the magnetic flux density.

**15.** Nuclear magnetic measuring device (1) according to any one of claims 1 to 14, **characterized in that** the control unit (6) is designed to determine a third property of the measuring signal path (16) **in that** the control unit (6) first sets the first changeover switch (8) into the second switching state and the second changeover switch (14) into the second switching state, and then generates a third test excitation signal, receives a third test reaction signal caused by the third test excitation signal, and, using the third test excitation signal and the third test reaction signal, determines a transmission function of the bypass signal path (20) as third property.

**16.** Nuclear magnetic measuring device (1) according to any one of claims 1 to 15, **characterized in that** the transmission unit (12) has a galvanic separation.

**17.** Nuclear magnetic measuring device (1) according to claim 16, **characterized in that** galvanic separation is implemented by an air transformer (21).

**18.** Nuclear magnetic measuring device (1) according to claim 16, **characterized in that** galvanic separation is implemented by a first air transformer (21) for transmission of signals from the bypass signal path (20) to the antenna signal path (19) and by a second air transformer (22) for transmission of signals from the antenna signal path (19) to the bypass signal path (20).

**Revendications**

**1.** Appareil de mesure magnétique nucléaire (1), comprenant un arrangement de mesure (4) destiné à réaliser des mesures magnétiques nucléaires sur un fluide (5),
l'arrangement de mesure (4) possédant un dispositif de commande (6), un dispositif générateur (7) destiné à générer des signaux d'excitation, un premier dispositif de conditionnement (9) destiné à conditionner les signaux d'excitation, un dispositif d'antenne (10) destiné à transmettre les signaux d'excitation conditionnés sur le fluide (5) et à détecter des signaux de réaction provoqués par les signaux d'excitation dans le fluide (5), un deuxième dispositif de conditionnement (13) destiné à conditionner les signaux de réaction, un dispositif de réception (15) destiné à recevoir les signaux de réaction conditionnés et un trajet de signal de mesure (16),
le trajet de signal de mesure (16) possédant un trajet de signal d'excitation (17) et un trajet de signal de réaction (18), le trajet de signal d'excitation (17) acheminant les signaux d'excitation depuis le dispositif générateur (7) jusque sur le fluide (5) en passant par le premier dispositif de conditionnement (9) et le dispositif d'antenne (10) et le trajet de signal de réaction (18) les signaux de réaction depuis le fluide (5) au dispositif de réception (15) en passant par le dispositif d'antenne (10) et le deuxième dispositif de conditionnement (13),
le dispositif d'antenne (10) possédant un trajet de signal d'antenne (19) et le trajet de signal d'excitation (17) et le trajet de signal de réaction (18) coïncidant dans le trajet de signal d'antenne (19),
**caractérisé en ce**
**que** l'arrangement de mesure (4) possède un trajet de signal de dérivation (20) et un dispositif de transmission (12), le trajet de signal de dérivation (20) et le dispositif de transmission (12) sont reliés ensemble et le dispositif de transmission (12) est configuré pour une transmission bidirectionnelle de signaux entre le trajet de signal de dérivation (20) et le trajet de signal d'antenne (19),
**qu'**un premier commutateur inverseur (8) est disposé de telle sorte que dans un premier état de commutation, le dispositif générateur (7) est relié au trajet de signal d'excitation (17) et dans un deuxième état de commutation, le dispositif générateur (7) est relié au trajet de signal de dérivation (20),
**qu'**un deuxième commutateur inverseur (14) est disposé de telle sorte que dans un premier état de commutation, le dispositif de réception (15) est relié au trajet de signal de réaction (18) et dans un deuxième état de commutation, le dispositif de réception (15) est relié au trajet de signal de dérivation (20),
**que** le dispositif de commande (6) est configuré pour commander tout d'abord le premier commutateur inverseur (8) et le deuxième commutateur inverseur (14) de telle sorte qu'une partie du trajet de signal de mesure (16) soit détournée par le trajet de signal de dérivation (20), et ensuite générer un signal d'excitation de test avec le dispositif générateur (7), recevoir avec le dispositif de réception (15) un signal de réaction de test provoqué par le signal d'excitation de test et déterminer une propriété du trajet de signal de mesure (16) en utilisant le signal d'excitation de test et le signal de réaction de test.

**2.** Appareil de mesure magnétique nucléaire (1) selon la revendication 1, **caractérisé en ce que** le dispositif de commande (6) est configuré pour réaliser la mesure magnétique nucléaire **en ce que** le dispositif de commande (6) amène tout d'abord le premier commutateur inverseur (8) dans le premier état de commutation et le deuxième commutateur inverseur (14) dans le premier état de commutation et génère ensuite un signal d'excitation de mesure, reçoit un signal de réaction de mesure provoqué par le signal d'excitation de mesure et détermine une information à propos du fluide (5) à partir du signal d'excitation de mesure et du signal de réaction de mesure.

3. Appareil de mesure magnétique nucléaire (1) selon la revendication 2, **caractérisé en ce que** le dispositif de commande (6) est configuré pour augmenter une précision de l'information à propos du fluide (5) en utilisant la propriété du trajet de signal de mesure (16) .

4. Appareil de mesure magnétique nucléaire (1) selon l'une des revendications 1 à 3, **caractérisé en ce que** le dispositif de commande (6) est configuré pour déterminer une première propriété du trajet de signal de mesure (16) **en ce que** le dispositif de commande (6) amène tout d'abord le premier commutateur inverseur (8) dans le deuxième état de commutation et le deuxième commutateur inverseur (14) dans le premier état de commutation et génère ensuite un premier signal d'excitation de test, reçoit un premier signal de réaction de test provoqué par le premier signal d'excitation de test et détermine, comme la première propriété, une amplification par le biais du trajet de signal de réaction (18) en utilisant le premier signal d'excitation de test et le premier signal de réaction de test.

5. Appareil de mesure magnétique nucléaire (1) selon la revendication 4 et la revendication 2 ou 3, **caractérisé en ce que** le dispositif de commande (6) est configuré pour effectuer au moins une détermination de la première propriété en-dehors de l'exécution de la mesure magnétique nucléaire.

6. Appareil de mesure magnétique nucléaire (1) selon la revendication 2 ou 3 et selon la revendication 4 ou 5, **caractérisé en ce que** le dispositif de commande (6) est configuré pour effectuer au moins une détermination de la première propriété pendant l'exécution de la mesure magnétique nucléaire.

7. Appareil de mesure magnétique nucléaire (1) selon l'une des revendications 4 à 6, **caractérisé en ce que** le dispositif de commande (6) est configuré pour effectuer au moins une première et une deuxième détermination de la première propriété et réaliser une interpolation de la première propriété entre les au moins une première et deuxième déterminations de la première propriété.

8. Appareil de mesure magnétique nucléaire (1) selon l'une des revendications 4 à 7, **caractérisé en ce que** le dispositif de commande (6) est configuré pour amener tout d'abord le premier commutateur inverseur (8) dans le premier état de commutation et le deuxième commutateur inverseur (14) dans le premier état de commutation et ensuite générer un premier signal d'excitation de référence, recevoir un premier signal de réaction de référence provoqué par le premier signal d'excitation de référence, déterminer une première amplitude de référence du premier signal de réaction de référence et, en utilisant le premier signal d'excitation de référence et le premier signal de réaction de référence, une amplification de référence du trajet de signal de réaction (18), et déterminer un facteur de correction d'amplification en utilisant la première amplitude de référence, l'amplification de référence et l'amplification par le biais du trajet de signal de réaction.

9. Appareil de mesure magnétique nucléaire (1) selon l'une des revendications 1 à 8, **caractérisé en ce que** le dispositif de commande (6) est configuré pour déterminer une deuxième propriété du trajet de signal de mesure (16) **en ce que** le dispositif de commande (6) amène tout d'abord le premier commutateur inverseur (8) dans le premier état de commutation et le deuxième commutateur inverseur (14) dans le deuxième état de commutation et génère ensuite un deuxième signal d'excitation de test, reçoit un deuxième signal de réaction de test provoqué par le deuxième signal d'excitation de test et détermine, comme la deuxième propriété, une densité de flux magnétique dans le fluide (5) en utilisant le deuxième signal d'excitation de test et le deuxième signal de réaction de test.

10. Appareil de mesure magnétique nucléaire (1) selon la revendication 9, **caractérisé en ce que** le dispositif de commande (6) est configuré pour intégrer la densité de flux magnétique sur un intervalle.

11. Appareil de mesure magnétique nucléaire (1) selon la revendication 2 ou 3 et selon la revendication 9 ou 10 et la revendication 2 ou 3, **caractérisé en ce que** le dispositif de commande (6) est configuré pour effectuer au moins une détermination de la deuxième propriété en-dehors de l'exécution de la mesure magnétique nucléaire.

12. Appareil de mesure magnétique nucléaire (1) selon l'une des revendications 9 à 11, **caractérisé en ce que** le dispositif de commande (6) est configuré pour effectuer au moins une détermination de la deuxième propriété pendant l'exécution de la mesure magnétique nucléaire et utiliser le signal d'excitation de mesure comme deuxième signal d'excitation de test.

**13.** Appareil de mesure magnétique nucléaire (1) selon l'une des revendications 9 à 12, **caractérisé en ce que** le dispositif de commande (6) est configuré pour effectuer au moins une première détermination et une deuxième détermination de la deuxième propriété et réaliser une interpolation de la deuxième propriété entre les au moins une première et deuxième déterminations de la deuxième propriété.

**14.** Appareil de mesure magnétique nucléaire (1) selon l'une des revendications 9 à 13, **caractérisé en ce que** le dispositif de commande (6) est configuré pour amener tout d'abord le premier commutateur inverseur (8) dans le premier état de commutation et le deuxième commutateur inverseur (14) dans le premier état de commutation et ensuite générer un deuxième signal d'excitation de référence, recevoir un deuxième signal de réaction de référence provoqué par le deuxième signal d'excitation de référence, déterminer une impulsion de 90° de référence et une densité de flux magnétique de référence en utilisant le deuxième signal d'excitation de référence et le deuxième signal de réaction de référence et déterminer une impulsion de 90° en utilisant l'impulsion de 90° de référence, la densité de flux magnétique de référence et la densité de flux magnétique.

**15.** Appareil de mesure magnétique nucléaire (1) selon l'une des revendications 1 à 14, **caractérisé en ce que** le dispositif de commande (6) est configuré pour déterminer une troisième propriété du trajet de signal de mesure (16) **en ce que** le dispositif de commande (6) amène tout d'abord le premier commutateur inverseur (8) dans le deuxième état de commutation et le deuxième commutateur inverseur (14) dans le deuxième état de commutation et génère ensuite un troisième signal d'excitation de test, reçoit un troisième signal de réaction de test provoqué par le troisième signal d'excitation de test et détermine, comme la troisième propriété, une fonction de transfert du trajet de signal de dérivation (20) en utilisant le troisième signal d'excitation de test et le troisième signal de réaction de test.

**16.** Appareil de mesure magnétique nucléaire (1) selon l'une des revendications 1 à 15, **caractérisé en ce que** le dispositif de transmission (12) possède une isolation galvanique.

**17.** Appareil de mesure magnétique nucléaire (1) selon la revendication 16, **caractérisé en ce que** l'isolation galvanique est mise en œuvre par un transformateur à refroidissement par air (21).

**18.** Appareil de mesure magnétique nucléaire (1) selon la revendication 16, **caractérisé en ce que** l'isolation galvanique est mise en œuvre par un premier transformateur à refroidissement par air (21) destiné à la transmission de signaux du trajet de signal de dérivation (20) vers le trajet de signal d'antenne (19) et un deuxième transformateur à refroidissement par air (22) destiné à la transmission de signaux du trajet de signal d'antenne (19) au trajet de signal de dérivation (20) .

Fig. 1

Fig. 2

Fig. 3a

Fig. 3b

EP 3 428 584 B1

Fig. 4a

Fig. 4b

Fig. 4c

Fig. 4d

Fig. 5a

Fig. 5b

Fig. 5c

Fig. 5d

Fig. 6a

Fig. 6b

Fig. 6c

Fig. 6d

**IN DER BESCHREIBUNG AUFGEFÜHRTE DOKUMENTE**

**In der Beschreibung aufgeführte Patentdokumente**

- EP 2733500 A1